# EUROPEAN PATENT APPLICATION

(11) **EP 4 502 252 A1**
(43) Date of publication of application: **05.02.2025**
(21) Application number: 23780977.7
(22) Date of filing: 30.03.2023
(51) Int. Cl.: C30B 29/38, C30B 25/20, H01L 21/205

(54) **GAN CRYSTAL AND GAN WAFER**

(30) Priority: 31.03.2022 JP 2022060641; 31.03.2022 JP 2022060642
(71) Applicant: Mitsubishi Chemical Corporation, Tokyo 100-8251 (JP)
(72) Inventor: TSUKADA, Yusuke, Tokyo 100-8251 (JP); ISHINABE, Takayuki, Tokyo 100-8251 (JP); TSUJII, Yutaka, Tokyo 100-8251 (JP); TAKAHASHI, Tatsuya, Tokyo 100-8251 (JP); IKEDA, Hirotaka, Tokyo 100-8251 (JP)
(74) Representative: Hoffmann Eitle
(86) International application number: PCT/JP2023/013363
(87) International publication number: WO 2023/190969

(57) **Abstract**

A GaN crystal with an angle between the normal line of a main surface and an m-axis of 0 degrees or more and 20 degrees or less is provided, in which the GaN crystal having, on the main surface thereof, a band-shaped dislocation-concentrated region that satisfies at least one requirement selected from the group consisting of (1) to (3) and a GaN wafer with a narrow width of the band-shaped dislocation-concentrated region present on the main surface and contribution to an improvement in the yield of a nitride semiconductor device:
(1) a maximum effective width is less than 50 µm;
(2) at least one of a requirement (A) or a requirement (B) is satisfied, where (A) a dislocation density (Dy) for a width of 15 µm from the center is less than 3 × 10⁷ cm⁻², and (B) a dislocation density (D_{Z}) for a width of 50 µm from the center is less than 2.5 × 10⁷ cm⁻²; and (3) a ratio (D_{Z}/D_{X}) of D_{Z} to D_{X} (a dislocation density D_{X} for a width of 5 µm from the center) is 0.5 or less, and/or D_{Z}/D_{Y} is 0.5 or less.

## Description

### TECHNICAL FIELD

The present invention relates to a gallium nitride (GaN) crystal and a GaN wafer.

### BACKGROUND ART

A GaN wafer obtained from a non-polar or semi-polar GaN crystal having a main surface inclined at a large angle with respect to a C-plane is expected as a substrate for a nitride semiconductor device with improved characteristics. The nitride semiconductor is also referred to as a nitride-based III-V compound semiconductor, a Group III nitride-based compound semiconductor, a GaN-based semiconductor, etc., and includes, besides GaN, compounds in which gallium (Ga) in GaN is partially or fully substituted with other Group 13 elements (B, Al, In) in the periodic table. Examples thereof include AlN, InN, AlGaN, AlInN, GaInN, AlGaInN, and other nitrides.

Among non-polar GaN wafers, (10-10) wafers, also known as M-plane wafers, are of particular interest. Among semi-polar GaN wafers, (20-21), (20-2-1), (30-31), and (30-3-1) wafers are of particular interest.

Non-polar or semi-polar GaN wafers can be produced by slicing bulk GaN crystals grown by a hydride vapor phase epitaxy (HVPE) method on a GaN (0001) surface of a C-plane GaN wafer or C-plane GaN template parallel to a desired non-polar or semi-polar plane. However, the area of a non-polar or semi-polar GaN wafer fabricated in this way is limited because the thickness of a GaN crystal that can be stably vapor-phase grown on a GaN (0001) surface is usually several mm or less. It is extremely difficult to industrially produce large area wafers such as 2-inch wafers (disk-shaped wafers with a diameter of about 50 mm) in this way.

In order to solve this problem, a tiling technique has been proposed. In the tiling technique, aggregate seeds are used. The aggregate seeds include a plurality of seeds densely arranged such that crystal orientations are aligned. A bulk GaN crystal forming one continuous layer is epitaxially grown on the aggregate seeds including the plurality of seeds by an HVPE method (Patent Documents 1 to 5). It is possible to achieve an M-plane GaN wafer having a diameter of about 50 mm by using aggregate seeds formed with a plurality of M-plane GaN wafers aggregated, each M-plane GaN wafer having a size of a main surface of less than several mm in the c-axis direction.

### PRIOR ART REFERENCES

### Patent Documents

Patent Document 1: JP 2006-315947 A
Patent Document 2: JP 2008-143772 A
Patent Document 3: JP 2010-275171 A
Patent Document 4: JP 2011-026181 A
Patent Document 5: WO 2017/010166 A

### SUMMARY OF THE INVENTION

### Object to be Achieved by the Invention

A bulk GaN crystal grown by the tiling technique includes the part with a low crystallinity, which is grown above the boundary between adjacent seeds. A non-polar or semi-polar GaN wafer produced by slicing such a bulk GaN crystal has a band-shaped dislocation-concentrated region where the part with a low crystallinity is exposed in a band shape on a main surface thereof.

In a case where a nitride semiconductor device is produced using a non-polar or semi-polar GaN wafer having a band-shaped dislocation-concentrated region on a main surface, an element formed immediately above the band-shaped dislocation-concentrated region will be inferior in characteristics and reliability to an element formed in another part on the same wafer. Thus, in a case where the width of the band-shaped dislocation-concentrated region can be reduced, the yield of nitride semiconductor devices produced using such non-polar or semi-polar GaN wafers will be improved.

Therefore, a major object of the present invention is to provide a GaN crystal and a GaN wafer, in which a width of a band-shaped dislocation-concentrated region present on a main surface is narrowed.

### Means for Achieving the Object

Embodiments of the present invention include a GaN crystal, a GaN wafer, and a method for producing a GaN crystal as described below.
<1> A GaN crystal including a main surface with an angle between a normal line of the main surface and an m-axis of 0 degrees or more and 20 degrees or less, in which
   the GaN crystal has one or more band-shaped dislocation-concentrated regions on the main surface, and
   the GaN crystal satisfies at least one requirement selected from the group consisting of (1), (2), and (3) as follows:
      (1) each band-shaped dislocation-concentrated region has a maximum effective width of less than 50 µm;
      (2) each band-shaped dislocation-concentrated region satisfies at least one of a requirement (A) or a requirement (B), where
         (A) a dislocation density in a region (Y) defined by two line segments drawn in parallel to a longitudinal direction of the band-shaped dislocation-concentrated region at positions of 15 µm from a center of the band-shaped dislocation-concentrated region in a lateral direction perpendicular to the longitudinal direction is less than 3 × 10⁷ cm⁻², and
         (B) a dislocation density in a region (Z) defined by two line segments drawn in parallel to a longitudinal direction of the band-shaped dislocation-concentrated region at positions of 50 µm from a center of the band-shaped dislocation-concentrated region in a lateral direction perpendicular to the longitudinal direction is less than 2.5 × 10⁷ cm⁻²; and
      (3) a ratio (D_{Z}/D_{X}) of the dislocation density D_{Z} to the dislocation density D_{X} defined below is 0.5 or less, and/or a ratio (D_{Z}/D_{Y}) of the dislocation density D_{Z} to the dislocation density Dy defined below is 0.5 or less, where
   the dislocation density Dx: a dislocation density in a region (X) defined by two line segments drawn in parallel to a longitudinal direction of the band-shaped dislocation-concentrated region at positions of 5 µm from a center of the band-shaped dislocation-concentrated region in a lateral direction perpendicular to the longitudinal direction;
   the dislocation density D_{Y}: a dislocation density in a region (Y) defined by two line segments drawn in parallel to a longitudinal direction of the band-shaped dislocation-concentrated region at positions of 15 µm from a center of the band-shaped dislocation-concentrated region in a lateral direction perpendicular to the longitudinal direction; and
   the dislocation density D_{Z}: a dislocation density in a region (Z) defined by two line segments drawn in parallel to a longitudinal direction of the band-shaped dislocation-concentrated region at positions of 50 µm from a center of the band-shaped dislocation-concentrated region in a lateral direction perpendicular to the longitudinal direction.
<2> The GaN crystal according to <1>, in which in the requirement (B), the dislocation density in the region (Z) defined by two line segments drawn in parallel to the longitudinal direction of the band-shaped dislocation-concentrated region at the positions of 50 µm from the center of the band-shaped dislocation-concentrated region in the lateral direction perpendicular to the longitudinal direction is less than 1 × 10⁷ cm⁻².
<3> The GaN crystal according to <1>, in which
   (2) each band-shaped dislocation-concentrated region satisfies the requirement (B), and
   in the requirement (B), the dislocation density in the region (Z) defined by two line segments drawn in parallel to the longitudinal direction of the band-shaped dislocation-concentrated region at the positions of 50 µm from the center of the band-shaped dislocation-concentrated region in the lateral direction perpendicular to the longitudinal direction is 1.0 × 10⁶ cm⁻² or more and less than 2.5 × 10⁷ cm⁻².
<4> The GaN crystal according to any one of <1> to <3>, in which the GaN crystal satisfies (1).
<5> The GaN crystal according to any one of <1> to <4>, in which the GaN crystal satisfies (2).
<6> The GaN crystal according to any one of <1> to <5>, in which the GaN crystal satisfies (3).
<7> The GaN crystal according to any one of <1> to <3>, in which the GaN crystal satisfies all of (1), (2), and (3).
<8> The GaN crystal according to any one of <1> to <7>, in which the main surface has an area of 10 cm² or more.
<9> The GaN crystal according to any one of <1> to <8>, in which a dislocation density in a region other than each band-shaped dislocation-concentrated region of the main surface is 1 × 10⁶ cm⁻² or less.
<10> The GaN crystal according to any one of <1> to <9>, in which the GaN crystal has a carbon concentration of 1 × 10¹⁷ cm⁻³ or less in crystal.
<11> The GaN crystal according to any one of <1> to <10>, in which an absorption coefficient is 1 cm⁻¹ or more at a wavelength of 445 nm, and an N-H peak at 3050 to 3300 cm⁻¹ in an infrared absorption spectrum is not observed.
<12> A GaN crystal including a main surface with an angle between a normal line of the main surface and an m-axis of 0 degrees or more and 20 degrees or less, in which
   the main surface has an area of 10 cm² or more, and
   in a case where a rectangular region of 210 µm × 100 µm is set at any position on the main surface, and a dislocation density in a rectangle is calculated, a rectangular region where the dislocation density in the rectangle is more than 1 × 10⁷ cm⁻² is not present on the main surface.
<13> The GaN crystal according to <12>, in which the GaN crystal has a carbon concentration of 1 × 10¹⁷ cm⁻³ or less in crystal.
<14> The GaN crystal according to <12> or <13>, in which an absorption coefficient is 1 cm⁻¹ or more at a wavelength of 445 nm, and an N-H peak at 3050 to 3300 cm⁻¹ in an infrared absorption spectrum is not observed.
<15> A GaN wafer including the GaN crystal according to any one of <1> to <14>.
<16> The GaN wafer according to <15>, in which the GaN wafer includes a {10-10} wafer, a {10-11} wafer, a {10-1-1} wafer, a {20-21} wafer, a {20-2-1} wafer, a {30-31} wafer, or a {30-3-1} wafer.
<17> A method for producing a GaN crystal, the method including at least: a liquid-phase growth process of growing a bulk GaN crystal by an ammonothermal method on aggregate seeds obtained by dense arrangement of a plurality of tiling GaN seeds; and a vapor-phase growth process of growing a GaN crystal by an HVPE method by using the bulk GaN crystal obtained in the liquid-phase growth process as a seed crystal, the liquid-phase growth process including a meltback process.
<18> A method for producing a GaN crystal, the method including at least: an aggregate seed-preparation process of preparing a seed aggregate including a plurality of tiling GaN seeds densely arranged; and a vapor-phase growth process of growing a GaN crystal on the aggregate seeds by an HVPE method, in which the aggregate seed-preparation process includes a process of removing an edge portion such that a (000-1) plane is not exposed at the edge portion consisting of an intersection of an end portion of a main surface on a (000-1) side and an end portion of the (000-1) plane of each tiling GaN seed.

### Effects of the Invention

A GaN crystal and a GaN wafer, in which a width of a band-shaped dislocation-concentrated region present on a main surface is narrowed, are provided.

### BRIEF DESCRIPTION OF THE DRAWINGS

Fig. 1 is a perspective view illustrating an example of an M-plane GaN crystal according to an embodiment.
Fig. 2(a) is a plan view of the M-plane GaN crystal illustrated in Fig. 1, and Fig. 2(b) is a cross-sectional view of the M-plane GaN crystal illustrated in Fig. 1.
Fig. 3 is a plan view illustrating an example of an M-plane GaN crystal according to an embodiment.
Fig. 4 is a light emission distribution image (SEM-CL image) illustrating an example of an M-plane GaN crystal according to Reference Example.
Fig. 5 is an integrated profile of image luminance obtained from Fig. 4.
Fig. 6 is a light emission distribution image (SEM-CL image) illustrating an example of an M-plane GaN crystal according to Reference Example.
Fig. 7 is a light emission distribution image (multi-photon excited PL image) illustrating an example of an M-plane GaN crystal according to an embodiment.
Fig. 8 is an integrated profile of image luminance obtained from Fig. 7.
Fig. 9 is a light emission distribution image (SEM-CL image) illustrating an example of an M-plane GaN crystal according to an embodiment.
Fig. 10 is an integrated profile of image luminance obtained from Fig. 9.
Fig. 11 is a plan view illustrating an example of the relationship between a band-shaped dislocation-concentrated region and a region (Y).
Fig. 12 is a plan view illustrating an example of a calculation method for a dislocation density in the region (Y).
Fig. 13 is a plan view illustrating an example of the relationship between a band-shaped dislocation-concentrated region and a region (Z).
Fig. 14 is a plan view illustrating an example of the relationship between a band-shaped dislocation-concentrated region and a region (X).
Fig. 15 is a plan view illustrating an example of the relationship between a band-shaped dislocation-concentrated region and a region (Z).
Fig. 16 is a plan view illustrating an example of a calculation method for a dislocation density in the region (Z).
Fig. 17 is a plan view illustrating an example of the relationship between a band-shaped dislocation-concentrated region and a region (X).
Fig. 18 is a plan view illustrating an example of the relationship between a band-shaped dislocation-concentrated region and a region (Y).
Fig. 19 is a view illustrating the relationship between an inclination θ of a main surface of a GaN crystal from an M-plane, and a c-axis direction component θc and an a-axis direction component θa.
Fig. 20 is a cross-sectional view of a tiling GaN seed in which angles, each formed by the front surface and a side surface, are obtuse angles (> 90°).
Fig. 21(a) is a cross-sectional view illustrating a plurality of tiling GaN seeds are densely arranged and attached to a surface of a planarized plate, and Fig. 21(b) is a cross-sectional view illustrating the plurality of tiling GaN seeds illustrated in Fig. 21(a) after a planarization process is performed.
Fig. 22 is a cross-sectional view illustrating that an unintended difference is generated between heights of seeds in a case where the plurality of tiling GaN seeds are densely arranged without "sagging treatment".
Fig. 23 is a cross-sectional view of a tiling GaN seed subjected to the "sagging treatment".
Fig. 24 is a cross-sectional view illustrating that an unintended difference is generated between heights of seeds in a case where the plurality of tiling GaN seeds are densely arranged with "sagging treatment".
Fig. 25 is a conceptual diagram of a vapor-phase growth apparatus used in an HVPE method.
Fig. 26 is a cross-sectional view of a complex containing aggregate seeds and a bulk GaN crystal epitaxially grown thereon.
Fig. 27 is a cross-sectional view after the complex illustrated in Fig. 26 is processed into a cylindrical shape, and broken lines indicate slice positions when the complex is sliced to obtain the GaN wafer illustrated in Fig. 1.

### MODES FOR CARRYING OUT THE INVENTION

In a GaN crystal, a crystal axis parallel to [0001] and [000-1] is referred to as a c-axis, a crystal axis parallel to <10-10> is referred to as an m-axis, and a crystal axis parallel to <11-20> is referred to as an a-axis. In addition, a crystal plane orthogonal to the c-axis is referred to as a C-plane, a crystal plane orthogonal to the m-axis is referred to as an M-plane, and a crystal plane orthogonal to the a-axis is referred to as an A-plane.

In the following, in a case of referring to a crystal axis, a crystal plane, a crystal orientation, and other structural properties, those mean a crystal axis, a crystal plane, a crystal orientation, and other structural properties of a GaN crystal unless otherwise specified.

The name or Miller index of a crystal plane appended to the name of a GaN crystal or wafer denotes a low-index plane that is parallel to or most closely parallel to the main surface, out of two main surfaces of the crystal or wafer, that is intended to be used for forming semiconductor devices or epitaxially growing a crystal.

For example, a GaN wafer in which a low-index plane parallel or most closely parallel to such a main surface is an M-plane, or in other words, {10-10} is referred to as an M-plane wafer or a {10-10} wafer.

In most cases, a crystal plane for which all of the absolute values of integers h, k, m, and l of Miller indices {hkml} are 3 or less is assumed to be a low-index plane.

In the present specification, the "GaN crystal" is a concept including not only a bulk GaN crystal, but also a bulk GaN crystal processed into a specific shape. In the present specification, the "GaN wafer" is a form of the "GaN crystal", but is used in a case where a bulk GaN crystal processed into a wafer shape is particularly distinguished and referred to such.

Hereinafter, the present invention will be described in accordance with embodiments with reference to the drawings as appropriate.

### 1. GaN Crystal

### 1.1 GaN Crystal

A first embodiment of the present invention relates to a GaN crystal.

A GaN crystal according to a first embodiment of the present invention is a GaN crystal including a main surface with an angle between a normal line of the main surface and an m-axis of 0 degrees or more and 20 degrees or less,
in which the GaN crystal has one or more band-shaped dislocation-concentrated regions on the main surface, and
the GaN crystal satisfies at least one requirement selected from the group consisting of (1), (2), and (3) as follows:
   (1) each band-shaped dislocation-concentrated region has a maximum effective width of less than 50 µm;
   (2) each band-shaped dislocation-concentrated region satisfies at least one of a requirement (A) or a requirement (B), where
      (A) a dislocation density D_{Y} is less than 3 × 10⁷ cm⁻², and
      (B) a dislocation density D_{Z} is less than 2.5 × 10⁷ cm⁻²; and
   (3) a ratio (D_{Z}/D_{X}) of the dislocation density D_{Z} to a dislocation density D_{X} is 0.5 or less, and/or a ratio (D_{Z}/D_{Y}) of the dislocation density D_{Z} to the dislocation density Dy is 0.5 or less.

The dislocation density D_{X}, the dislocation density D_{X}, and the dislocation density D_{X} are defined as follows.

Dislocation density Dx: a dislocation density in a region (X) defined by two line segments drawn in parallel to a longitudinal direction of a band-shaped dislocation-concentrated region at positions of 5 µm from a center of the band-shaped dislocation-concentrated region in a lateral direction perpendicular to the longitudinal direction.

Dislocation density D_{Y}: a dislocation density in a region (Y) defined by two line segments drawn in parallel to a longitudinal direction of a band-shaped dislocation-concentrated region at positions of 15 µm from a center of the band-shaped dislocation-concentrated region in a lateral direction perpendicular to the longitudinal direction; and

Dislocation density D_{Z}: a dislocation density in a region (Z) defined by two line segments drawn in parallel to a longitudinal direction of a band-shaped dislocation-concentrated region at positions of 50 µm from a center of the band-shaped dislocation-concentrated region in a lateral direction perpendicular to the longitudinal direction.

An example of the GaN crystal according to the first embodiment of the present invention includes a GaN crystal having a main surface with an angle between a normal line of the main surface and an m-axis of 0 degrees or more and 20 degrees or less,
in which the GaN crystal has one or more band-shaped dislocation-concentrated regions on the main surface,
the GaN crystal satisfies at least one requirement selected from the group consisting of (1), (2-1), and (3-1) as follows:
   (1) each band-shaped dislocation-concentrated region has a maximum effective width of less than 50 µm;
   (2-1) each band-shaped dislocation-concentrated region satisfies at least one of a requirement (A) or a requirement (B-1), where
   (A) a dislocation density Dy is less than 3 × 10⁷ cm⁻², and
   (B-1) a dislocation density D_{Z} is less than 1 × 10⁷ cm⁻²; and
   (3-1) a ratio (D_{Z}/D_{X}) of the dislocation density D_{Z} to a dislocation density D_{X} is 0.5 or less.

The GaN crystal in this example can be produced, for example, by the following method.

A method for producing a GaN crystal, the method including at least: a liquid-phase growth process of growing a bulk GaN crystal by an ammonothermal method on aggregate seeds obtained by dense arrangement of a plurality of tiling GaN seeds; and a vapor-phase growth process of growing a GaN crystal by an HVPE method by using the bulk GaN crystal obtained in the liquid-phase growth process as a seed crystal, the liquid-phase growth process including a meltback process.

Another example of the GaN crystal according to the first embodiment of the present invention includes a GaN crystal having a main surface with an angle between a normal line of the main surface and an m-axis of 0 degrees or more and 20 degrees or less,
in which the GaN crystal has one or more band-shaped dislocation-concentrated regions on the main surface,
the GaN crystal satisfies at least one requirement selected from the group consisting of (1), (2-2), and (3) as follows:
   (1) each band-shaped dislocation-concentrated region has a maximum effective width of less than 50 µm;
   (2-2) each band-shaped dislocation-concentrated region satisfies a requirement (B-2) described blow, where
   (B-2) a dislocation density D_{Z} is 1.0 × 10⁶ cm⁻² or more and less than 2.5 × 10⁷ cm⁻²; and
   (3) a ratio (D_{Z}/D_{X}) of the dislocation density D_{Z} to a dislocation density D_{X} is 0.5 or less, and/or a ratio (D_{Z}/D_{Y}) of the dislocation density D_{Z} to the dislocation density Dy is 0.5 or less.

The GaN crystal in this example can be produced, for example, by the following method.

A method for producing a GaN crystal, the method including at least: an aggregate seed-preparation process of preparing aggregate seeds including a plurality of tiling GaN seeds densely arranged; and a vapor-phase growth process of growing a GaN crystal on the aggregate seeds by an HVPE method, in which the aggregate seed-preparation process includes a process of removing an edge portion such that a (000-1) plane is not exposed at the edge portion consisting of an intersection of an end portion of a main surface on a (000-1) side and an end portion of the (000-1) plane of each tiling GaN seed.

Details of the production method will be described later.

As a result of the study by the present inventors, it has been found that a region where defects are increased above and around a boundary of the plurality of tiling GaN seeds constituting the aggregate seeds, that is, a band-shaped dislocation-concentrated region may occur because the quality of a GaN crystal layer grown above and around the boundary is poor. Based on this finding, once a high-quality GaN crystal layer is formed above and around the boundary of the plurality of tiling GaN seeds constituting the aggregate seeds, it is possible to achieve a GaN crystal in which the occurrence of the band-shaped dislocation-concentrated region is reduced, and the width of the band-shaped dislocation-concentrated region is narrowed as compared to that in the related art.

In addition, as a result of the study by the present inventors, it has been found that a region where defects are increased above and around a boundary, that is, a band-shaped dislocation-concentrated region may occur because the (000-1) plane is exposed at the edge portion of a seed on the boundary between the plurality of tiling GaN seeds constituting the aggregate seeds. Based on this finding, once the (000-1) plane is not exposed at the edge portion between the plurality of tiling GaN seeds constituting the aggregate seeds, it is possible to achieve a GaN crystal in which the occurrence of the band-shaped dislocation-concentrated region is reduced, and the width of the band-shaped dislocation-concentrated region is narrowed as compared to that in the related art.

The present inventors have found that the GaN crystal in which the width of the band-shaped dislocation-concentrated region is narrowed, specifically, the GaN crystal satisfying at least one selected from the group consisting of (1), (2), and (3) can be obtained, for example, by a production method described later.

The GaN crystal according to the first embodiment of the present invention may satisfy any one selected from the group consisting of (1), (2), and (3), may satisfy any two of them, or may satisfy all of them. The GaN crystal of the present invention preferably satisfies at least (1), more preferably satisfies (1) and (2) or (1) and (3), and still more preferably satisfies all of (1), (2), and (3).

### 1.2. Band-Shaped Dislocation-Concentrated Region

The GaN crystal according to the first embodiment (hereinafter, may be referred to as "the present embodiment") has a band-shaped dislocation-concentrated region on the main surface. The band-shaped dislocation-concentrated region is a region in which dislocations are concentrated at a relatively high density extends in a band shape. The dislocation referred to herein is an end point of a threading dislocation (edge dislocation, helical dislocation, or mixed dislocation).

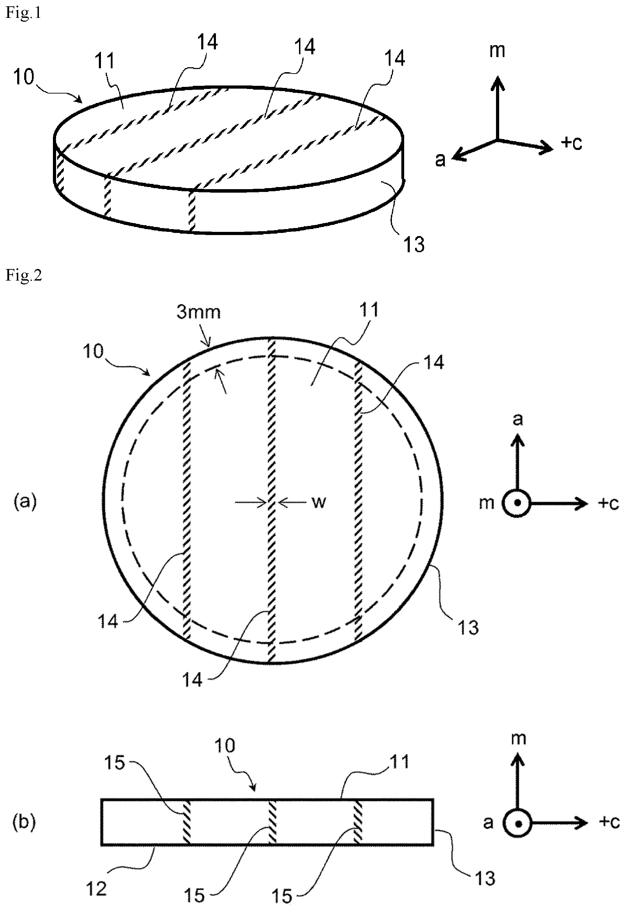

A plurality of band-shaped dislocation-concentrated regions may be periodically arranged on the main surface of the GaN crystal according to the present embodiment. Figs. 1 and 2 are a perspective view and a plan view illustrating an example of such a GaN crystal. A GaN crystal 10 has a plurality of band-shaped dislocation-concentrated regions 14 arranged periodically on a first main surface 11.

A band-shaped dislocation-concentrated region on the main surface may extend in a longitudinal direction at an orientation of 0 degrees or more and 20 degrees or less from the c-axis or 0 degrees or more and 20 degrees or less from the a-axis.

In addition, the GaN crystal according to the first embodiment may have, on the main surface, a band-shaped dislocation-concentrated region extends in a longitudinal direction at an orientation of 0 degrees or more and 20 degrees or less from the a-axis, in addition to a band-shaped dislocation-concentrated region extends in a longitudinal direction at an orientation of 0 degrees or more and 20 degrees or less from the c-axis.

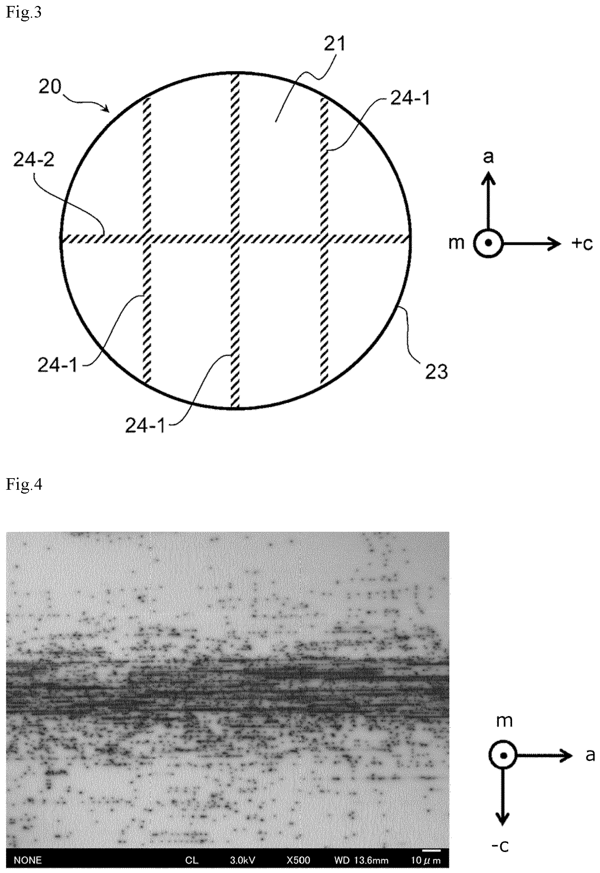

Fig. 3 is a plan view illustrating an example of such a GaN crystal.

Referring to Fig. 3, a GaN crystal 20 has a disk shape and has, on a first main surface 21, band-shaped dislocation-concentrated regions 24-1 extending in a direction orthogonal to the c-axis and a band-shaped dislocation-concentrated region 24-2 extending in a direction orthogonal to the a-axis.

Referring again to Fig. 2, the number of band-shaped dislocation-concentrated regions 14 provided on the first main surface 11 of the GaN crystal 10 is not limited to three, and may be four or more, but are desirably six or less. In a case where the GaN crystal 10 has a diameter of 45 to 55 mm, the number of crystallinity reduction bands 14 is preferably two, and more preferably one.

The band-shaped dislocation-concentrated region is a region in which dislocations are concentrated at a relatively high density extends in a band shape and is observed in a case where a bulk GaN crystal is grown by a method using the aggregate seeds described later to fabricate a GaN wafer from a surface of a bulk GaN crystal or a bulk GaN crystal thereof. Specifically, in the bulk GaN crystal grown on the aggregate seeds, a portion that is grown above the boundary between seed substrates constituting the aggregate seeds with a high defect density appears as a band-shaped dislocation-concentrated region on a surface of the bulk GaN crystal or a surface of a GaN wafer resulting from a process. Typically, the band-shaped dislocation-concentrated region is derived from a defect caused by bonding failure at the boundary between a plurality of tiling GaN seeds constituting the aggregate seeds. As described below, a band-shaped dislocation-concentrated region may be present on a main surface of a bulk GaN crystal grown by using a tiling technique, and a main surface of a GaN wafer formed from the bulk GaN crystal. Furthermore, a band-shaped dislocation-concentrated region may also be present on a main surface of a bulk GaN crystal grown by using a GaN crystal having a main surface on which a band-shaped dislocation-concentrated region is present as a seed, and a main surface of a GaN wafer fabricated from the bulk GaN crystal.

In a case where a light emission distribution image of a crystal plane is acquired by a scanning electron microscope-cathodoluminescence (SEM-CL) apparatus, a multi-photon excited photoluminescence (PL) microscope, a PL imaging apparatus, or other apparatuses, dislocations in the crystal are observed as dark spots, that is, points having lower image luminance than surroundings, in the light emission distribution image. At the boundary between the band-shaped dislocation-concentrated region and other regions, the density of dark spots observed in the above-described light emission distribution image is significantly different. The band-shaped dislocation-concentrated region has the image luminance in the light emission distribution image lower than that in a region other than the band-shaped dislocation-concentrated region and can be distinguished by observation. Here, the density of dark spots observed by an apparatus capable of observing the dark spots is synonymous with the dislocation density described above.

In order to accurately measure the density of dark spots in the regions where dislocations are present at high density in the crystal, high spatial resolution may be required. This is because, in a case where the spatial resolution is poor, the separation of individual dark spots is impossible in the light emission distribution image, resulting in the inability to measure the number of dark spots accurately. In general, the SEM-CL apparatus is superior in spatial resolution to a multi-photon excited PL microscope or a PL imaging apparatus. Therefore, also in the present specification, the SEM-CL apparatus and the multi-photon excited PL microscope can be selectively used as necessary in order to measure the density of dark spots.

### 1.3. Requirement (1)

The GaN crystal according to the present embodiment satisfies at least one requirement selected from the group consisting of (1), (2), and (3).

Requirement (1) is as follows.
(1) A band-shaped dislocation-concentrated region has a maximum effective width of less than 50 µm.

As the requirement (1), the band-shaped dislocation-concentrated region is only sufficient to have a maximum effective width of less than 50 µm, but the maximum effective width is preferably 40 µm or less, more preferably 30 µm or less, still more preferably 20 µm or less, from the viewpoint of improving the crystal quality. The band-shaped dislocation-concentrated region is only sufficient to have a maximum effective width of 1 µm or more.

In the present specification, the maximum effective width of the band-shaped dislocation-concentrated region refers to a maximum value in an effective width of the band-shaped dislocation-concentrated region present on the main surface. In a case where a plurality of band-shaped dislocation-concentrated regions present on the main surface, it refers to a maximum value of effective widths thereof.

In the present specification, the effective width of the band-shaped dislocation-concentrated region is defined as follows.

The effective width of the band-shaped dislocation-concentrated region on the main surface of the GaN crystal is examined by the observation on the light emission distribution image obtained using the apparatus capable of observing the dark spots as described above. For a section of 240 µm in the longitudinal direction of the band-shaped dislocation-concentrated region, an integrated value of image luminance profiles on a virtual line segment including the entire band-shaped dislocation-concentrated region and drawn to have a length of 180 µm in a direction perpendicular to the longitudinal direction is obtained. In the integrated luminance profile, a region other than the band-shaped dislocation-concentrated region has a relatively high luminance and is flat, while the band-shaped dislocation-concentrated region has a relatively low luminance. The flat region in the integrated luminance profile is extrapolated to draw a baseline. In the present specification, the effective width of the band-shaped dislocation-concentrated region is defined as a distance between both end points of a region having an image luminance of 80% or less with respect to the value of the image luminance at the baseline in the integrated luminance profile. The integrated luminance profile may be fitted to obtain a curve, and the curve may be used for determining the effective width of the band-shaped dislocation-concentrated region. In the present specification, the center of the band-shaped dislocation-concentrated region refers to a midpoint between two end points of the effective width. As will be described later, in a case where there is no region having an image luminance of 80% or less with respect to the value of the image luminance at the baseline in the integrated luminance profile, and the effective width of the band-shaped dislocation-concentrated region is indeterminable, the center of the band-shaped dislocation-concentrated region observed in the light emission distribution image is visually determined.

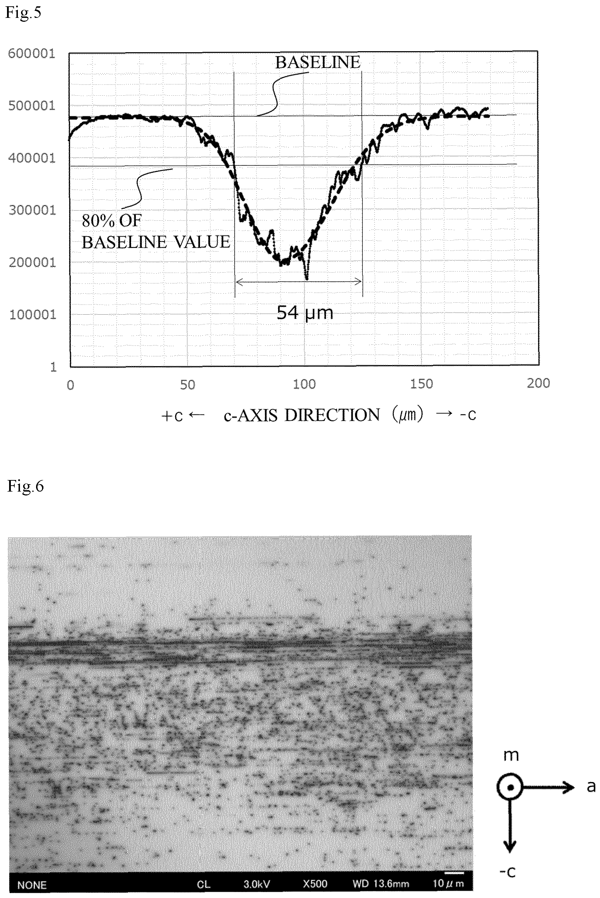

Fig. 4 is a light emission distribution image (SEM-CL image) around a band-shaped dislocation-concentrated region on a main surface of a GaN crystal of Reference Example, and the region of 240 µm × 180 µm has been observed. The dark spots are present at high density, and a SEM-CL apparatus is used for measuring the density of dark spots. In Fig. 4, the longitudinal direction of the band-shaped dislocation-concentrated region is a direction parallel to the a-axis. In the SEM-CL image of Fig. 4, a result of integrating image luminance profiles on a line segment having a length of 180 µm perpendicular to the longitudinal direction in a section of the band-shaped dislocation-concentrated region having a section of 240 µm in the longitudinal direction is illustrated in Fig. 5. In Fig. 5, the distance between both end points of the region having the image luminance of 80% or less with respect to the value of the image luminance at the baseline was about 54 µm. In Fig. 4, a solid line indicates an actual measurement value of integrated luminance, and a broken line indicates a result of fitting a curve of the actual measurement value.

When the effective width of the band-shaped dislocation-concentrated region is calculated, in the integrated luminance profile within the region of 240 µm × 180 µm, there may be a case that no flat region corresponding to the region other than the band-shaped dislocation-concentrated region is present, and thus the baseline is not obtained within the range of the integrated luminance profile. Such a case is typically observed in a situation where dislocations derived from defects propagated from the bonding portions of the aggregate seeds are distributed at high density over a wide area. Since such a situation means that the band-shaped dislocation-concentrated region is present in a wide range, it is determined that the effective width of the band-shaped dislocation-concentrated region is 50 µm or more in such a case. Fig. 6 is a light emission distribution image (SEM-CL image) around a band-shaped dislocation-concentrated region on a main surface of a GaN crystal of Reference Example and is the above case.

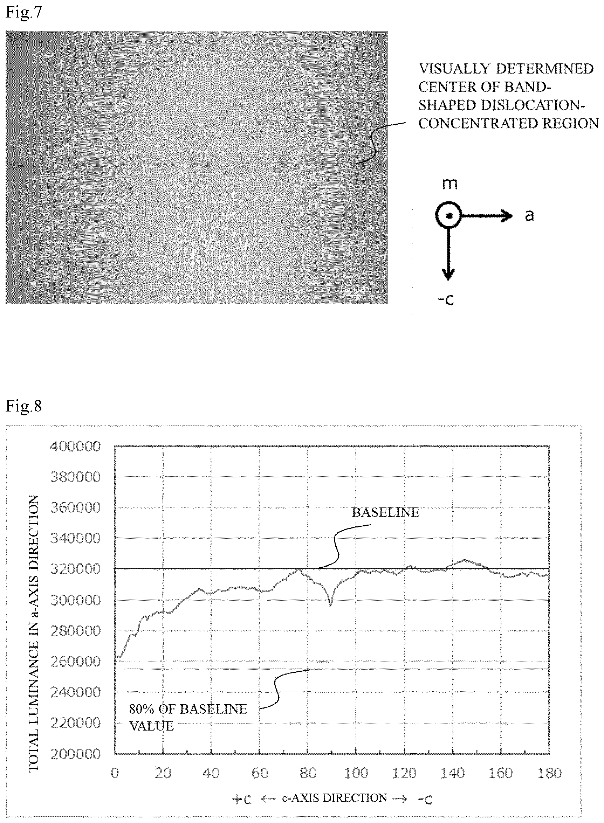

In another case, when the width of the band-shaped dislocation-concentrated region is calculated, in the integrated luminance profile, a region having an image luminance of 80% or less with respect to the value of the image luminance at the baseline may not be present. Such a case is typically observed in a situation where the occurrence of dislocations derived from defects propagated from the bonding portions of the aggregate seeds is effectively controlled, so that the width of the band-shaped dislocation-concentrated region is substantially and extremely narrow. Since such a situation means that the band-shaped dislocation-concentrated region is extremely narrow, it is determined that the effective width of the band-shaped dislocation-concentrated region is less than 50 µm in such a case. Fig. 7 is a light emission distribution image (multi-photon excited PL image) around a band-shaped dislocation-concentrated region on a main surface of a GaN crystal of Examples and is the above case. Fig. 8 is the integrated image luminance profile obtained from the multi-photon excited PL image in Fig. 7, and there is no region having an image luminance of 80% or less with respect to the image luminance value at the baseline. Note that, in Fig. 7, the luminance on the +c side is dark as a whole, and accordingly, the numerical value of the integrated luminance on the +c side is low in Fig. 8, but this is considered to be an artifact occurring in the outer peripheral region of the visual field of the multi-photon excited PL image. In such a case, a planarization process is performed on the integrated image luminance profile as necessary.

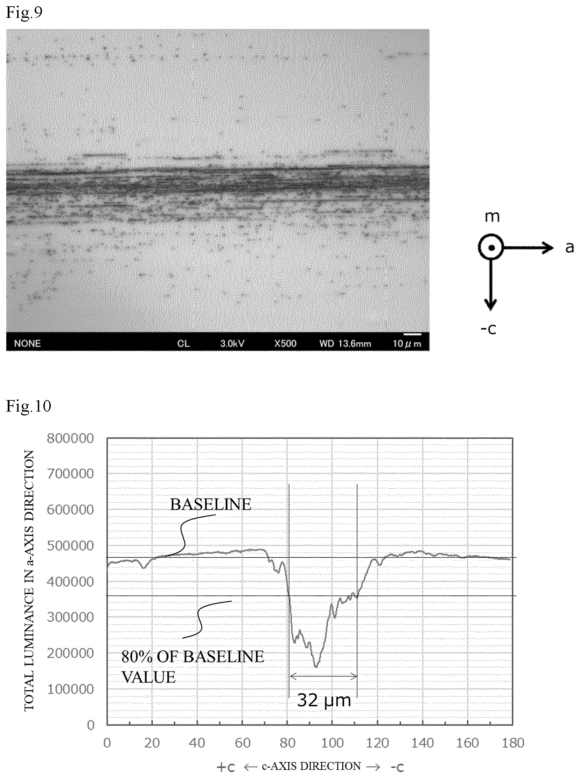

Fig. 9 is an example of the light emission distribution image (SEM-CL image) around the band-shaped dislocation-concentrated region on the main surface of the GaN crystal according to the embodiment. Fig. 10 is the integrated profile of image luminance obtained from the SEM-CL image in Fig. 9, and the distance between both end points in the region having an image luminance of 80% or less with respect to the image luminance value at the baseline is about 32 µm.

In the related art, the evaluation on FWHM of the X-ray rocking curve (XRC) is usually performed using a commercially available X-ray diffractometer as the evaluation of the band-shaped dislocation-concentrated region occurring above the boundary between the aggregate seeds used in a tiling technique. A so-called spatial resolution of the FWHM of XRC is determined by the interval between measurement points for XRC measurement, but as the width of the band-shaped dislocation-concentrated region decreases, it becomes difficult to accurately measure the width of the band-shaped dislocation-concentrated region with the spatial resolution of XRC measurement using a general X-ray diffractometer. That is, in a case where the width of the band-shaped dislocation-concentrated region is small, the conventional XRC measurement cannot be said to be an appropriate evaluation method. According to the observation on the light emission distribution image by an apparatus capable of observing the dark spots, the width of the band-shaped dislocation-concentrated region can be quantitatively evaluated even when the width of the band-shaped dislocation-concentrated region is small.

### 1.4. Requirement (2)

Requirement (2) is as follows.

(2) The band-shaped dislocation-concentrated region satisfies at least one of the following requirement (A) or (B).
(A) A dislocation density (dislocation density D_{Y}) in a region (Y) defined by two line segments drawn in parallel to a longitudinal direction of a band-shaped dislocation-concentrated region at positions of 15 µm from a center of the band-shaped dislocation-concentrated region in a lateral direction perpendicular to the longitudinal direction is less than 3 × 10⁷ cm⁻².
(B) A dislocation density (dislocation density D_{Z}) in a region (Z) defined by two line segments drawn in parallel to a longitudinal direction of a band-shaped dislocation-concentrated region at positions of 50 µm from a center of the band-shaped dislocation-concentrated region in a lateral direction perpendicular to the longitudinal direction is less than 2.5 × 10⁷ cm⁻².

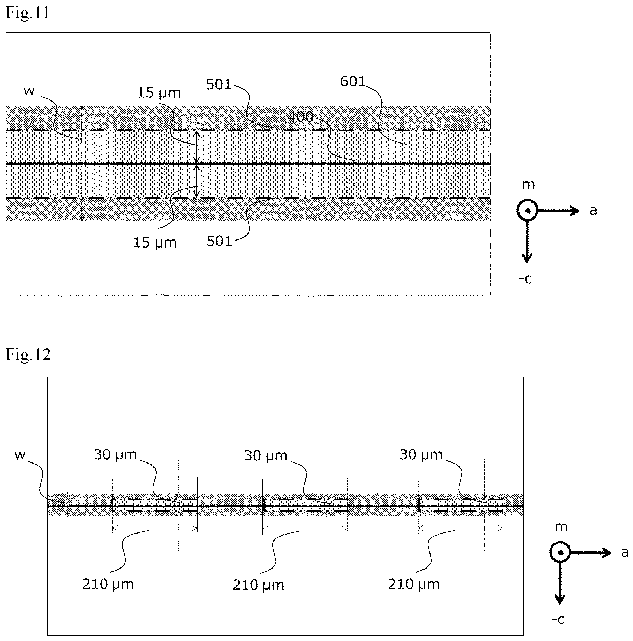

By the requirement (A), the dislocation density D_{Y} of less than 3 × 10⁷ cm⁻² is necessary. It can also be said that the region (Y) is a region defined by a quadrangle whose center coincides with the center of the band-shaped dislocation-concentrated region and whose length in a direction perpendicular to the longitudinal direction of the band-shaped dislocation-concentrated region is 30 µm. Fig. 11 is a schematic diagram illustrating an example of the relationship between the band-shaped dislocation-concentrated region on the main surface of the GaN crystal and the region (Y). In Fig. 11, the longitudinal direction of the band-shaped dislocation-concentrated region is a direction parallel to the a-axis. A region (Y) 601 is defined by two line segments 501 drawn in parallel to a longitudinal direction of a band-shaped dislocation-concentrated region at positions of 15 µm from a center 400 of the band-shaped dislocation-concentrated region in a lateral direction perpendicular to the longitudinal direction.

In a case where the band-shaped dislocation-concentrated region is derived from a defect occurring at the boundary between the aggregate seeds used in the tiling technique, the dislocations constituting the band-shaped dislocation-concentrated region are not observed exclusively immediately above the bonding surface between the aggregate seeds. During the growth of a GaN crystal layer on the aggregate seeds, a dislocation propagates to the periphery of a bonding surface of the aggregate seed, resulting in distribution of the dislocation at high density over the peripheral region immediately above the bonding surface of the aggregate seeds. Therefore, the fact that the dislocation density Dy is low means that the number of dislocations occurring at the bonding portion between the aggregate seeds is reduced, and the number of dislocations propagating to the periphery of the bonding portion is also reduced.

The dislocation density Dy is only sufficient to be less than 3 × 10⁷ cm⁻², but is preferably less than 1 × 10⁷ cm⁻², more preferably less than 5 × 10⁶ cm⁻², and still more preferably less than 1 × 10⁶ cm⁻² from the viewpoint of further improving the crystal quality. The smaller the dislocation density Dy, the better, but the lower limit thereof is usually 1 × 10³ cm⁻².

The dislocation density D_{Y} can be calculated by measurement on the density of dark spots observed in a light emission distribution image acquired using an apparatus capable of observing dark spots. The dislocation density is calculated by setting a length of a band-shaped dislocation-concentrated region in the longitudinal direction in the region (Y) to a specific length to be used as an observation region, and averaging dislocation densities calculated for a plurality of observation regions for the same band-shaped dislocation-concentrated region. For describing the calculation method with a specific example, in a case where the length of the band-shaped dislocation-concentrated region in the longitudinal direction, serving as the observation region, is set to 210 µm, the observation region is defined by a rectangle of 210 µm × 30 µm. For the same band-shaped dislocation-concentrated region, two or three observation regions of 210 µm × 30 µm are set so that the observation regions are not overlapped with each other, and the dislocation densities calculated for the individual observation regions are averaged to obtain the dislocation density (dislocation density D_{Y}) in the region (Y). In a case where a plurality of band-shaped dislocation-concentrated regions are present on the main surface, an area of the measurement regions is determined as described above, two or three measurement regions are set for each of the band-shaped dislocation-concentrated regions so that the observation regions are not overlapped with each other, and the dislocation densities calculated for all the set measurement regions are averaged to obtain the dislocation density in the region (Y). Fig. 12 is a schematic diagram illustrating a case of the above-described specific example. In Fig. 12, three different observation regions of 210 µm × 30 µm are set for the same band-shaped dislocation-concentrated region.

By the requirement (B), the dislocation density D_{Z} of less than 2.5 × 10⁷ cm⁻² is necessary. It can also be said that the region (Z) is a region defined by a quadrangle whose center coincides with the center of the band-shaped dislocation-concentrated region and whose length in a direction perpendicular to the longitudinal direction of the band-shaped dislocation-concentrated region is 100 µm.

The requirement (B) is preferably the requirement (B-1) or (B-2).

By the requirement (B-1), the dislocation density D_{Z} of less than 1 × 10⁷ cm⁻² is necessary.

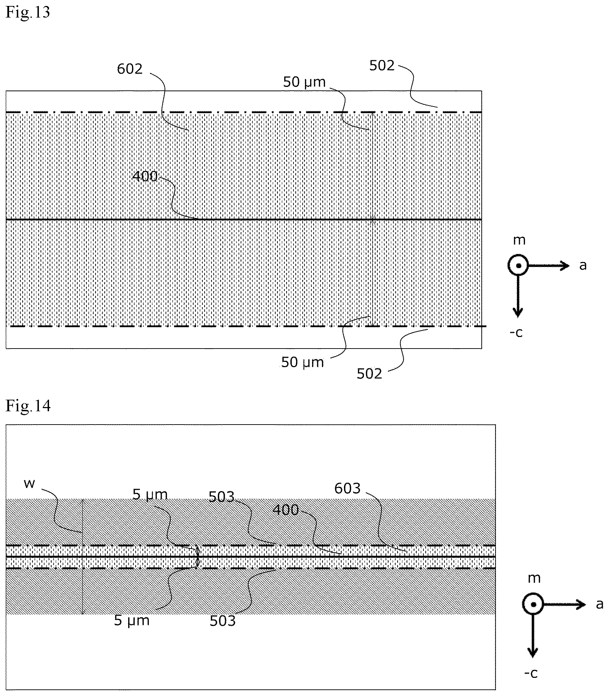

Fig. 13 is a schematic diagram illustrating an example of the relationship between the band-shaped dislocation-concentrated region on the main surface of the GaN crystal and the region (Z). In Fig. 13, the longitudinal direction of the band-shaped dislocation-concentrated region is a direction parallel to the a-axis. A region (Z) 602 is defined by two line segments 502 drawn in parallel to a longitudinal direction of a band-shaped dislocation-concentrated region at positions of 50 µm from a center 400 of the band-shaped dislocation-concentrated region in a lateral direction perpendicular to the longitudinal direction.

In the requirement (B-1), the dislocation density D_{Z} is only sufficient to be less than 1 × 10⁷ cm⁻², but is preferably less than 8 × 10⁶ cm⁻², more preferably less than 5 × 10⁶ cm⁻², and still more preferably less than 1 × 10⁶ cm⁻² from the viewpoint of further improving the crystal quality. The smaller the dislocation density D_{Z}, the better, but the lower limit thereof is usually 1 × 10⁴ cm⁻².

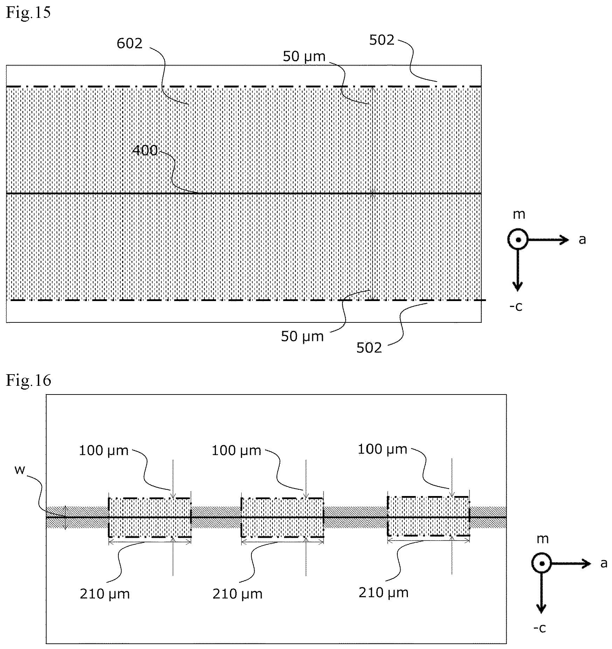

By the requirement (B-2), the dislocation density D_{Z} of 1.0 × 10⁶ cm⁻² or more and less than 2.5 × 10⁷ cm⁻² is necessary. Fig. 15 is a schematic diagram illustrating an example of the relationship between the band-shaped dislocation-concentrated region on the main surface of the GaN crystal and the region (Z). In Fig. 15, the longitudinal direction of the band-shaped dislocation-concentrated region is a direction parallel to the a-axis. A region (Z) 602 is defined by two line segments 502 drawn in parallel to a longitudinal direction of a band-shaped dislocation-concentrated region at positions of 50 µm from a center 400 of the band-shaped dislocation-concentrated region in a lateral direction perpendicular to the longitudinal direction.

In a case where the band-shaped dislocation-concentrated region is derived from a defect occurring at the boundary between the aggregate seeds used in the tiling technique, the dislocations constituting the band-shaped dislocation-concentrated region are not observed exclusively immediately above the bonding surface between the aggregate seeds. During the growth of a GaN crystal layer on the aggregate seeds, a dislocation propagates to the periphery of a bonding surface of the aggregate seed, resulting in distribution of the dislocation at high density over the peripheral region immediately above the bonding surface of the aggregate seeds. Therefore, the fact that the dislocation density is less than 2.5 × 10⁷ cm⁻² in the region (Z) including the center of the band-shaped dislocation-concentrated region means that the number of dislocations occurring at the bonding portion between the aggregate seeds is reduced, and the number of dislocations propagating to the periphery of the bonding portion is also reduced.

In the requirement (B-2), the dislocation density D_{Z} is only sufficient to be 1.0 × 10⁶ cm⁻² or more and less than 2.5 × 10⁷ cm⁻², but is preferably less than 2.2 × 10⁷ cm⁻² and more preferably less than 2 × 10⁷ cm⁻² from the viewpoint of further improving the crystal quality. The dislocation density D_{Z} is preferably 2 × 10⁶ cm⁻² or more, and more preferably 5 × 10⁶ cm⁻² or more.

The dislocation density D_{Z} can be calculated by measurement on the density of dark spots observed in a light emission distribution image acquired using an apparatus capable of observing dark spots. The dislocation density is calculated by setting a length of a band-shaped dislocation-concentrated region in the longitudinal direction in the region (Z) to a specific length to be used as an observation region, and averaging dislocation densities calculated for a plurality of observation regions for the same band-shaped dislocation-concentrated region. For describing the calculation method with a specific example, in a case where the length of the band-shaped dislocation-concentrated region in the longitudinal direction, serving as the observation region, is set to 210 µm, the observation region is defined by a rectangle of 210 µm × 100 µm. For the same band-shaped dislocation-concentrated region, two or three observation regions of 210 µm × 100 µm are set so that the observation regions are not overlapped with each other, and the dislocation densities calculated for the individual observation regions are averaged to obtain the dislocation density D_{Z}. In a case where a plurality of band-shaped dislocation-concentrated regions are present on the main surface, an area of the measurement regions is determined as described above, two or three measurement regions are set for each of the band-shaped dislocation-concentrated regions so that the observation regions are not overlapped with each other, and the dislocation densities calculated for all the set measurement regions are averaged to obtain the dislocation density D_{Z}. Fig. 16 is a schematic diagram illustrating a case of the above-described specific example. In Fig. 16, three different observation regions of 210 µm × 100 µm are set for the same band-shaped dislocation-concentrated region.

As the requirement (2), the GaN crystal is only sufficient to have a band-shaped dislocation-concentrated region satisfying at least one of a condition (A) or a condition (B), but may have a band-shaped dislocation-concentrated region satisfying both the condition (A) and the condition (B). For example, it is preferable to have a band-shaped dislocation-concentrated region that satisfies the condition (A), to have a band-shaped dislocation-concentrated region that satisfies both the condition (A) and a condition (B-1), to have a band-shaped dislocation-concentrated region that satisfies the condition (B-1), or to have a band-shaped dislocation-concentrated region that satisfies the condition (B-2).

### 1.5. Requirement (3)

Requirement (3) is as follows.

(3-1) The ratio (D_{Z}/D_{X}) of the dislocation density D_{Z} to the dislocation density D_{X} is 0.5 or less, and/or the ratio (D_{Z}/D_{Y}) of the dislocation density D_{Z} to the dislocation density D_{Y} is 0.5 or less.

The requirement (3) may include the following requirement (3-1).

(3-1) The ratio (D_{Z}/D_{X}) of the dislocation density D_{Z} to the dislocation density D_{X} is 0.5 or less.

In a case where the band-shaped dislocation-concentrated region is derived from a defect occurring at the boundary between the aggregate seeds used in the tiling technique, the dislocations constituting the band-shaped dislocation-concentrated region are not observed exclusively immediately above the bonding surface between the aggregate seeds. During the growth of a GaN crystal layer on the aggregate seeds, a dislocation propagates to the periphery of a bonding surface of the aggregate seed, resulting in distribution of the dislocation at high density over the peripheral region immediately above the bonding surface of the aggregate seeds. Therefore, the fact that the ratio D_{Z}/D_{X} of the dislocation density D_{Z} in the region (Z) including the center of the band-shaped dislocation-concentrated region to the dislocation density D_{X} in the region (X) including the center of the band-shaped dislocation-concentrated region is small means that the number of dislocations occurring at the bonding portion between the aggregate seeds is reduced, and the number of dislocations propagating to the periphery of the bonding portion is also reduced.

In the requirement (3-1), the ratio D_{Z}/D_{X} of the dislocation density D_{Z} to the dislocation density D_{X} is only sufficient to be 0.5 or less, but is preferably 0.45 or less, more preferably 0.40 or less, and still more preferably 0.35 or less from the viewpoint of further improving the crystal quality.

The method of calculating the dislocation density D_{X} and the dislocation density D_{Z} can be performed in the same manner as the method of calculating the dislocation density D_{Y} in the requirement (2). Fig. 14 is a schematic diagram illustrating an example of the relationship between the band-shaped dislocation-concentrated region on the main surface of the GaN crystal and the region (X). In Fig. 14, the longitudinal direction of the band-shaped dislocation-concentrated region is a direction parallel to the a-axis. A region (X) 603 is defined by two line segments 503 drawn in parallel to a longitudinal direction of a band-shaped dislocation-concentrated region at positions of 5 µm from a center 400 of the band-shaped dislocation-concentrated region in a lateral direction perpendicular to the longitudinal direction.

In the requirement (3), the ratio (D_{Z}/D_{X}) of the dislocation density D_{Z} to the dislocation density D_{X} is 0.5 or less, and/or the ratio (D_{Z}/D_{Y}) of the dislocation density D_{Z} to the dislocation density Dy is 0.5 or less.

In a case where the band-shaped dislocation-concentrated region is derived from a defect occurring at the boundary between the aggregate seeds used in the tiling technique, the dislocations constituting the band-shaped dislocation-concentrated region are not observed exclusively immediately above the bonding surface between the aggregate seeds. During the growth of a GaN crystal layer on the aggregate seeds, a dislocation propagates to the periphery of a bonding surface of the aggregate seed, resulting in distribution of the dislocation at high density over the peripheral region immediately above the bonding surface of the aggregate seeds. Therefore, the fact that the ratio D_{Z}/D_{X} of the dislocation density D_{Z} in the region (Z) including the center of the band-shaped dislocation-concentrated region to the dislocation density D_{X} in the region (X) including the center of the band-shaped dislocation-concentrated region and/or the ratio (D_{Z}/D_{Y}) of the dislocation density D_{Z} in the region (Z) including the center of the band-shaped dislocation-concentrated region to the dislocation density D_{Y} in the region (Y) including the center of the band-shaped dislocation-concentrated region is small means that the number of dislocations occurring at the bonding portion between the aggregate seeds is reduced, and the number of dislocations propagating to the periphery of the bonding portion is also reduced.

In the requirement (3), at least one of the ratio D_{Z}/D_{X} of the dislocation density D_{Z} to the dislocation density D_{X} or the ratio D_{Z}/D_{Y} of the dislocation density D_{Z} to the dislocation density D_{Y} is only sufficient to be 0.5 or less, but from the viewpoint of further improving the crystal quality, at least one of the ratio D_{Z}/D_{X} of the dislocation density D_{Z} to the dislocation density D_{X} or the ratio D_{Z}/D_{Y} of the dislocation density D_{Z} to the dislocation density Dy is preferably 0.45 or less, at least one of the ratio D_{Z}/D_{X} of the dislocation density D_{Z} to the dislocation density D_{X} or the ratio D_{Z}/D_{Y} of the dislocation density D_{Z} to the dislocation density D_{Y} is more preferably 0.40 or less, and at least one of the ratio D_{Z}/D_{X} of the dislocation density D_{Z} to the dislocation density D_{X} or the ratio D_{Z}/D_{Y} of the dislocation density D_{Z} to the dislocation density D_{Y} is still more preferably 0.35 or less. In addition, both the ratio D_{Z}/D_{X} of the dislocation density D_{Z} to the dislocation density D_{X} and the ratio D_{Z}/D_{Y} of the dislocation density D_{Z} to the dislocation density Dy are preferably 0.5 or less, both may be 0.45 or less, both may be 0.40 or less, or both may be 0.35 or less.

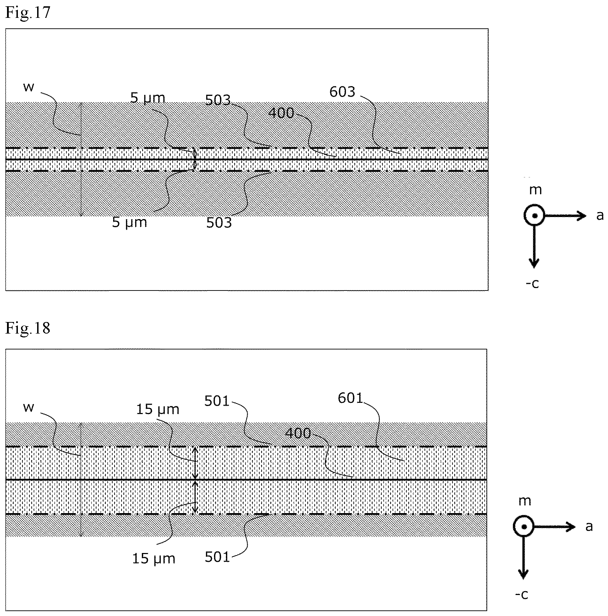

The method of calculating the dislocation density D_{X} and the dislocation density D_{Y} can be performed in the same manner as the method of calculating the dislocation density in the region (Z), in the requirement (2). Fig. 17 is a schematic diagram illustrating an example of the relationship between the band-shaped dislocation-concentrated region on the main surface of the GaN crystal and the region (X). In Fig. 17, the longitudinal direction of the band-shaped dislocation-concentrated region is a direction parallel to the a-axis. A region (X) 603 is defined by two line segments 503 drawn in parallel to a longitudinal direction of a band-shaped dislocation-concentrated region at positions of 5 µm from a center 400 of the band-shaped dislocation-concentrated region in a lateral direction perpendicular to the longitudinal direction. Fig. 18 is a schematic diagram illustrating an example of the relationship between the band-shaped dislocation-concentrated region on the main surface of the GaN crystal and the region (Y). In Fig. 18, the longitudinal direction of the band-shaped dislocation-concentrated region is a direction parallel to the a-axis. A region (Y) 601 is defined by two line segments 501 drawn in parallel to a longitudinal direction of a band-shaped dislocation-concentrated region at positions of 15 µm from a center 400 of the band-shaped dislocation-concentrated region in a lateral direction perpendicular to the longitudinal direction.

### 1.6. Main Surface

In the present embodiment, the GaN crystal has a main surface with the angle between the normal line of the main surface and the m-axis of 0 degrees or more and 20 degrees or less. That is, at least one of a first main surface or a second main surface of the GaN crystal has the angle between the normal line of any main surface and the m-axis of 0 degrees or more and 20 degrees or less.

At least one of the first main surface or second main surface of the GaN crystal may be inclined at the angle between the normal line of any main surface and the m-axis of more than 5°. The inclined direction is not limited, but it is preferable that in a case where the angle between the normal line of the main surface and the m-axis is decomposed into a c-axis direction component and an a-axis direction component, the absolute value of the c-axis direction component is greater than the absolute value of the a-axis direction component.

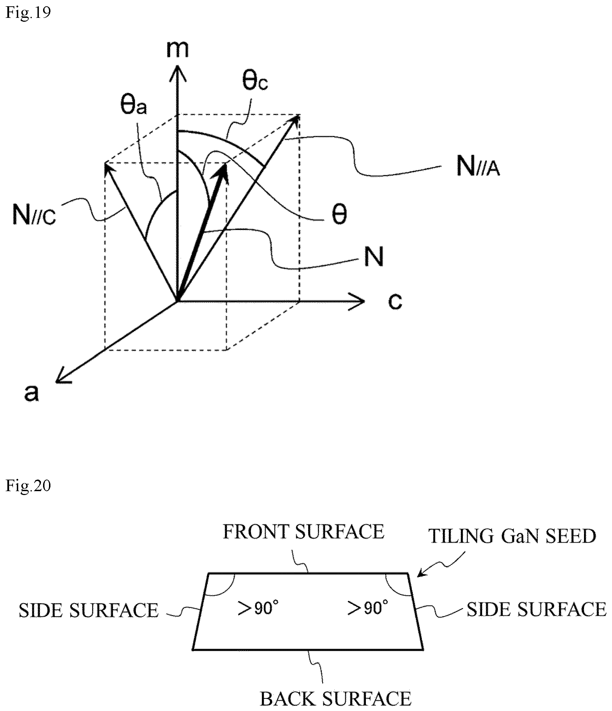

The relationship between an inclination of a main surface of a GaN crystal from an M-plane, and a c-axis direction component and an a-axis direction component is as illustrated in Fig. 19.

In other words, the inclination of the main surface of the GaN crystal from the M-plane is an inclination θ of a normal vector N of the main surface from the m-axis. In order to decompose the inclination θ into the c-axis direction component and the a-axis direction component, the normal vector N is decomposed into an A-plane parallel component N//A and a C-plane parallel component N//C. The A-plane parallel component N//A is an orthogonal projection of the normal vector N onto an A-plane, and the C-plane parallel component N//C is an orthogonal projection of the normal vector N onto a C-plane. The inclination of the A-plane parallel component N//A with respect to the m-axis is the c-axis direction component θc of the inclination θ, and the inclination of the C-plane parallel component N//C with respect to the m-axis is the a-axis direction component θa of the inclination θ.

The absolute value of the a-axis direction component is preferably 5° or less, still more preferably less than 2°, and still more preferably less than 1°. As the absolute value of the a-axis direction component is smaller, a nitride semiconductor thin film having a high surface planarization on the main surface is easily grown.

On the other hand, the absolute value of the c-axis direction component is usually 45° or less, preferably less than 30°, and more preferably less than 20°. In a case where the absolute value of the c-axis direction component is more than 45°, the benefits of the semi-polar wafer tend to be at risk of being lost. The c-axis direction component may be positive or negative but is preferably negative. Here, the positive c-axis direction component means that the A-plane parallel component N//A of the normal vector of the first main surface is inclined to the [0001] side with respect to the m-axis, and the negative c-axis direction component means that the A-plane parallel component N//A of the normal vector of the first main surface is inclined to the [000-1] side with respect to the m-axis.

Preferred examples of GaN crystals with the angle between the normal line of the main surface and the m-axis inclined by more than 5° include {10-11} crystals, {10-1-1} crystals, {20-21} crystals, {20-2-1} crystals, {30-31} crystals, and {30-3-1} crystals.

In the {10-11} crystals, {20-21} crystals, and {30-31} crystals, the c-axis direction component with the angle between the normal line of the main surface and the m-axis is positive, and in the {10-1-1} crystals, {20-2-1} crystals, and {30-3-1} crystals, the c-axis direction component with the angle between the normal line of the main surface and the m-axis is negative.

In a particularly preferred example, the absolute value of the c-axis direction component at the inclination of the first main surface with respect to the M-plane is 2° to 5°, and the absolute value of the a-axis direction component is less than 1°.

In the GaN crystal according to the present embodiment, the "first main surface" is a main surface intended to be used for epitaxial growth of a nitride semiconductor in a case where a nitride semiconductor device is manufactured by using the GaN crystal for a GaN substrate, that is, a "front surface". The first main surface is mirror-finished, and the root mean square (RMS) roughness thereof measured by AFM is preferably less than 2 nm in a measurement range of 2 µm × 2 µm, and may be less than 1 nm or less than 0.5 nm.

The "second main surface" is a "back surface" facing a direction opposite to the "first main surface", and may be mirror-finished or matte finished.

In the present specification, unless otherwise specified, the "main surface" is used to refer to the "first main surface" and the "second main surface" collectively without distinction.

In the GaN crystal according to the present embodiment, the area of the main surface is preferably 10 cm² or more. In a case where a GaN wafer is obtained from such a GaN crystal, the productivity of device manufacturing using the GaN wafer is improved. From the same viewpoint, the area of the main surface is more preferably 15 cm² or more, and still more preferably 20 cm² or more. The upper limit of the area of the main surface is not particularly limited, but is usually 300 cm² or less. In addition, in a case where a rectangular region of 210 µm × 100 µm is set at any position on the main surface to calculate the dislocation density in the rectangle, it is preferable that there is no rectangular region with the dislocation density in the rectangle of more than 1 × 10⁷ cm⁻² on the main surface.

In the GaN crystal according to the present embodiment, the dislocation density in a region other than the band-shaped dislocation-concentrated region of the main surface is preferably 1 × 10⁶ cm⁻² or less. In this case, the crystal quality of the GaN crystal is excellent. From the same viewpoint, the dislocation density in the region other than the band-shaped dislocation-concentrated region of the main surface is more preferably 8 × 10⁵ cm⁻² or less, and still more preferably 5 × 10⁵ cm⁻² or less. The lower limit of the dislocation density is not particularly limited, but is usually 1 × 10³ cm⁻² or more.

### 1.7. GaN Crystal

In another aspect, a GaN crystal according to the present embodiment includes a main surface with an angle between a normal line of the main surface and an m-axis of 0 degrees or more and 20 degrees or less, in which the main surface has an area of 10 cm² or more, and in a case where a rectangular region of 210 µm × 100 µm is set at any position on the main surface, and a dislocation density in the rectangle is calculated, a rectangular region where the dislocation density in the rectangle is more than 1 × 10⁷ cm⁻² is not present on the main surface. The GaN crystal may include one or more band-shaped dislocation-concentrated regions on the main surface.

In a case where a rectangular region of 210 µm × 100 µm is set at any position on the main surface to calculate the dislocation density in the rectangle, not a single rectangular region with the dislocation density in the rectangle of more than 1 × 10⁷ cm⁻² can be found on the main surface in the GaN crystal.

For example, for a conventional GaN crystal having a band-shaped dislocation-concentrated region whose width is not sufficiently reduced, in a case where the above-described rectangular region of 210 µm × 100 µm is set to cover the band-shaped dislocation-concentrated region, the dislocation density of the rectangular region is more than 1 × 10⁷ cm⁻². In other words, in a case where the rectangular region of 210 µm × 100 µm is set at any position on the main surface, and the dislocation density in the rectangle is calculated, the GaN crystal in which the rectangular region where the dislocation density in the rectangle is more than 1 × 10⁷ cm⁻² is not present on the main surface means a GaN crystal that has a band-shaped dislocation-concentrated region with a sufficiently narrow width and the excellent crystal quality.

From the same viewpoint, in the GaN crystal, in a case where the rectangular region of 210 µm × 100 µm is set at any position on the main surface to calculate the dislocation density in the rectangle, it is preferable that a rectangular region with a dislocation density in the rectangle of more than 5 × 10⁶ cm⁻² is not present on the main surface, it is more preferable that a rectangular region with a dislocation density in the rectangle of more than 1 × 10⁶ cm⁻² is not present on the main surface, and it is still more preferable that a rectangular region with a dislocation density in the rectangle of more than 5 × 10⁵ cm⁻² is not present on the main surface.

For the calculation of the dislocation density in the rectangle, the same method as that described above for the dislocation density D_{Y} can be applied.

Note that, a region of up to 1 mm inward from the outer peripheral edge of the GaN crystal can be excluded from the "any position on the main surface".

### 1.8. Specific Examples and Others

Fig. 1 is a perspective view illustrating an example of a GaN crystal according to the present embodiment. Fig. 2(a) is a plan view of the GaN crystal 10 illustrated in Fig. 1. Fig. 2(b) is a cross-sectional view of the GaN crystal 10 illustrated in Fig. 1, and illustrates a cut surface formed by cutting along a plane orthogonal to the a-axis.

Referring to Figs. 1 and 2, the GaN crystal 10 is an M-plane wafer having a disk shape, and has a first main surface 11 and a second main surface 12 that is opposite to the first main surface. The first main surface 11 and the second main surface 12 are connected with the side surface 13 sandwiched therebetween. The first main surface 11 and the second main surface 12 are preferably parallel to each other.

As the GaN crystal according to the present embodiment, the GaN crystal 10 illustrated in Figs. 1 and 2 may be variously modified.

In the GaN crystal according to the first embodiment, the main surface may have a shape other than a circle, and may have, for example, a rectangular shape (square or rectangular).

A diameter DW of the GaN crystal according to the present embodiment is usually 10 mm or more, and may be 20 mm or more, or 45 mm or more, and is typically 50 to 55 mm (about 2 inches), 100 to 105 mm (about 4 inches), 150 to 155 mm (about 6 inches), or other diameters.

The GaN crystal 10 has a thickness that can be handled as a free-standing wafer. For a disk-shaped GaN crystal with a diameter of 45 to 55 mm (about 2 inches), the minimum thickness necessary for handling of the free-standing wafer is 150 to 200 µm, a preferred thickness is 250 µm or more, a still more preferred thickness is 280 µm or more. As the diameter increases, the preferred thickness also increases.

There is no particular upper limit to the thickness of the GaN crystal 10, and in most cases, the thickness of the GaN crystal 10 is 1 mm or less and preferably 400 µm or less for a wafer having a diameter of 45 to 55 mm.

The GaN crystal according to the present embodiment preferably has a carbon concentration of 1 × 10¹⁷ cm⁻³ or less in crystal. In a case where the carbon concentration in crystal is within the above range, there is no possibility that carbon contained in the crystal adversely affects the performance of a semiconductor device obtained using a GaN crystal, which is preferable. The carbon concentration in crystal is more preferably 8 × 10¹⁶ cm⁻³ or less, still more preferably 5 × 10¹⁶ cm⁻³ or less, even still more preferably 2 × 10¹⁶ cm⁻³ or less, and particularly preferably 5 × 10¹⁵ cm⁻³ or less. The carbon concentration in crystal can be measured with secondary ion mass spectrometry (SIMS). In a case where a GaN crystal is obtained by crystal growth with the HVPE method, it may be usually considered that the carbon concentration in crystal is 1 × 10¹⁷ cm⁻³ or less without intentional carbon doping. For the reference, according to the results of experiments performed by the inventors in the past, the carbon concentration of a GaN crystal obtained by crystal growth of an m-plane seed crystal with the HVPE method without intentional carbon doping was measured by SIMS to obtain a result of 2 × 10¹⁶ cm⁻³ or less. In addition, in a case where a GaN crystal is obtained by crystal growth with the acidic ammonothermal method, it may be generally considered that the carbon concentration in crystal is 1 × 10¹⁷ cm⁻³ or less without intentional carbon doping. For the reference, according to the results of experiments performed by the inventors in the past, the carbon concentration of a GaN crystal obtained by crystal growth of an m-plane seed crystal with the acidic ammonothermal method without intentional carbon doping was measured by SIMS to obtain a result of about 7 × 10¹⁵ cm⁻³ to 2 × 10¹⁶ cm⁻³.

The GaN crystal according to the present embodiment may have an absorption coefficient of 1 cm⁻¹ or more at a wavelength of 445 nm, and may be provided without an N-H peak being observed at 3050 to 3300 cm⁻¹ in an infrared absorption spectrum. The fact that the GaN crystal has an absorption coefficient of 1 cm⁻¹ or more at a wavelength of 445 nm and is provided without a N-H peak being observed at 3050 to 3300 cm⁻¹ in an infrared absorption spectrum means that such a GaN crystal is not produced by an ammonothermal method. For example, the GaN crystal obtained by crystal growth with the HVPE method usually has an absorption coefficient of 1 cm⁻¹ or more at a wavelength of 445 nm, and is provided without an N-H peak being observed at 3050 to 3300 cm⁻¹ in an infrared absorption spectrum.

### 2. Application

The GaN crystal according to the present embodiment can be used as a substrate used for manufacturing various nitride semiconductor devices. In most cases, one or more kinds of nitride semiconductors are subjected to vapor phase epitaxial growth on the GaN crystal according to the present embodiment to form a device structure. As the epitaxial growth method, an MOCVD method, an MBE method, a pulse vapor deposition method, or other methods suitable for forming a thin film can be preferably used.

Specific examples of the nitride semiconductor devices include light emitting devices such as a light emitting diode and a laser diode, electronic devices such as a rectifier, a bipolar transistor, a field effect transistor, and a high electron mobility transistor (HEMT), semiconductor sensors such as a temperature sensor, a pressure sensor, a radiation sensor, and a visible-ultraviolet light detector, a surface acoustic wave (SAW) device, a vibrator, a resonator, an oscillator, a micro electro mechanical system (MEMS) component, a voltage actuator, a solar cell, and other semiconductor devices.

### 3. Method for Producing GaN Crystal

A second embodiment of the present invention relates to a method for producing a GaN crystal.

The method for producing a GaN crystal according to the second embodiment includes at least a liquid-phase growth process and a vapor-phase growth process described below. As necessary, a wafer fabrication process can be provided to produce a GaN wafer.
· Liquid-phase growth process: a process of growing a bulk GaN crystal by an ammonothermal method on aggregate seeds obtained by dense arrangement of a plurality of tiling GaN seeds
· Vapor-phase growth process: a process of growing a bulk GaN crystal by an HVPE method using the bulk GaN crystal obtained in the liquid-phase growth process as a seed crystal
· Wafer fabrication process: a process of fabricating a GaN wafer with an angle between the normal line of the main surface and the m-axis of 0 degrees or more and 20 degrees or less from the bulk GaN crystal obtained in the vapor-phase growth process

In an example of a preferred aspect, a method for producing a GaN crystal includes at least: a liquid-phase growth process of growing a bulk GaN crystal by an ammonothermal method on aggregate seeds obtained by dense arrangement of a plurality of tiling GaN seeds, and a vapor-phase growth process of growing a GaN crystal by an HVPE method by using the bulk GaN crystal obtained in the liquid-phase growth process as a seed crystal, in which the liquid-phase growth process includes a meltback process.

### 3.1. Liquid-Phase Growth Process

The liquid-phase growth process may further independently include the following steps 1 to 5.

Step 1: A GaN crystal is grown in a [000-1] direction on a (000-1) surface of a C-plane GaN seed by an ammonothermal method.

Step 2: An M-plane GaN seed is produced from the GaN crystal grown in the [000-1] direction in Step 1.

Step 3: A bulk GaN crystal is grown on the M-plane GaN seed produced in Step 2 described above by an ammonothermal method.

Step 4: A tiling GaN seed is produced from the bulk GaN crystal grown in Step 3.

Step 5: Aggregate seeds are produced by using the tiling GaN seed produced in Step 4, and bulk GaN crystal is grown on the obtained aggregated seed by an ammonothermal method.

Alternatively, the liquid-phase growth process can include Step 5' and Step 6' instead of step 5 in addition to the Steps 1 to 4 described above.

Step 5': The tiling GaN seed produced in Step 4 described above is subjected to sagging treatment.

Step 6': A bulk GaN crystal is grown by a tiling technique using the tiling GaN seed that has been subjected to the sagging treatment in Step 5' described above.

In either case, the following Step 7 can be further included.

Step 7: A GaN wafer having a desired plane orientation is fabricated from the bulk GaN crystal grown in Step 5 or Step 6' described above.

In an example of a preferred aspect, a method for producing a GaN crystal includes at least: an aggregate seed-preparation step of preparing aggregate seeds including a plurality of tiling GaN seeds densely arranged; and a vapor-phase growth process of growing a GaN crystal on the aggregate seeds by an HVPE method, in which the aggregate seed-preparation step includes a step of removing an edge portion such that a (000-1) plane is not exposed at the edge portion consisting of an intersection of an end portion of a main surface on a (000-1) side and an end portion of the (000-1) plane of each tiling GaN seed.

Hereinafter, details of each step in the liquid-phase growth process will be described.

### (Step 1)

In Step 1, a growth mask having a stripe pattern (line and space pattern) formed by using a TiW alloy on a (000-1) surface (nitrogen polar surface) of a normal C-plane GaN wafer is used as a C-plane GaN seed. The stripe direction of the growth mask is parallel to the a-axis of GaN, and the width of each opening portion is 100 µm, for example. The side surface of the C-plane GaN wafer is not covered with the growth mask.

For crystal growth apparatuses and crystal growth conditions used in a case where a GaN crystal is grown on the C-plane GaN seed by an ammonothermal method, see WO 2014/129544 A and WO 2015/020161 A.

Under appropriate conditions, a GaN crystal grown in the [000-1] direction at the position of each opening portion of the growth mask on the (000-1) surface of the C-plane GaN seed to form a wall-like structure with the c-axis direction as the height direction and the m-axis direction as the thickness direction.

For example, growth proceeds for a total of 100 days while growth vessel replacement is carried out on the way. As a result, the height (the size of the grown GaN crystal in the c-axis direction) of the wall may reach 20 mm.

The growth of the GaN crystal also occur on the side surface of the C-plane GaN seed. The GaN crystals grow from all of side surfaces of the C-plane GaN seed and extend in the [000-1] direction to form a peripheral wall structure surrounding a plurality of wall-like GaN crystals grown on the (000-1) surface of the seed.

### (Step 2)

In Step 1, the GaN crystals wall-like grown on the (000-1) surface of the C-plane GaN seed are removed from the seed and processed to obtain an M-plane GaN seed. The M-plane GaN seed is a plate-like crystal having main surfaces substantially parallel to the M-plane.

The main surfaces of the M-plane GaN seed are both planarized by lapping and then subjected to CMP finishing to remove a damaged layer.

### (Step 3)

A GaN crystal is grown on the M-plane GaN seed produced in Step 2 described above by an ammonothermal method. The GaN crystal grows to cover the entire surface of the M-plane GaN seed. The growth direction of the GaN crystal on the main surface of the M-plane GaN seed is the m-axis direction.

### (Step 4)

The GaN crystal grown in Step 3 is sliced in parallel to the M-plane, and an edge portion of the obtained GaN crystal plate is cut off with a dicing saw to produce a tiling GaN seed having a rectangular main surface whose long side is orthogonal to the c-axis and whose short side is orthogonal to the a-axis.

The main surface of the tiling GaN seed may be slightly inclined from the M-plane by adjusting the slice angle.

The side surface of the tiling GaN seed is a cut surface formed when the GaN crystal plate is cut with the dicing saw. Every time cutting is performed, the orientation of the formed cut surface is checked by the X-ray diffraction method, and operations of adjusting the direction of the workpiece in a case where the deviation from the design orientation is more than 0.1°, and performing the cutting again are repeatedly performed. As a result, the deviation at the side surface of the tiling GaN seed from the design orientation can be kept within 0.1°.

In a case where the GaN crystal plate is cut by the dicing saw, it is desirable that the saw blade is brought into contact with the GaN crystal plate from a surface that will become a back surface in the next Step 5. Out of two main surfaces of a tiling GaN seed, the back surface refers to a main surface opposite to the main surface used for epitaxial growth of a bulk GaN crystal as the front surface (the same applies hereinafter).

The reason is to avoid an obtuse angle to be formed by the front surface and the side surface in the tiling GaN seed. Since the thickness of the blade of the dicing saw decreases toward the tip, the angle formed by the front surface and the side surface (cut surface) is likely to be an obtuse angle (>90°) as illustrated in the cross-sectional view of Fig. 20 in a case where the blade is brought into contact with the tiling GaN seed from the front surface side and cuts the tiling GaN seed.

In a case where the angle between the front surface and the side surface is a right angle or an acute angle, it is possible to avoid the occurrence of the gap between the front surfaces of adjacent seeds when a plurality of tiling GaN seeds are densely arranged.

The GaN crystal plate obtained by cutting with the dicing saw is desirably subjected to lapping treatment and wet etching treatment in order to remove a damaged layer on an end surface that is the cut surface by the dicing saw. The end surface of the GaN crystal plate serves as the bonding surface between adjacent seeds when the GaN crystal plate is densely arranged as a tiling GaN seed, and at the time of cutting by the dicing saw, a damaged layer may be formed on the end surface serving as the cut surface. In a case where the damaged layer remains on the end surface, the bonding at the bonding portion between adjacent seeds is defective, and crystal defects derived from the bonding portion may occur. As a result of studies by the inventors, it has been found that the above-described lapping treatment and wet etching treatment are particularly useful in the tiling GaN seed having an M-plane or an S-plane as a main surface. The reason for this is considered as follows. In the case where the tiling GaN seed has an M-plane or an S-plane as the main surface, as compared with the case where the tiling GaN seed has a C-plane as the main surface, the effect of removing the damaged layer on the bonding surface by a meltback process (treatment of dissolving a GaN crystal layer on a seed surface by reversing a temperature) described later is relatively small. Thus, the damaged layer on the end surface is more effectively removed by performing the lapping treatment and the wet etching treatment on the end surface, resulting in a more effective reduction of the crystal defects in the bonding portion.

Both main surfaces of the tiling GaN seed are commonly subjected to a planarization process. Specifically, after grinding and/or lapping is performed, the damaged layer is removed by CMP.

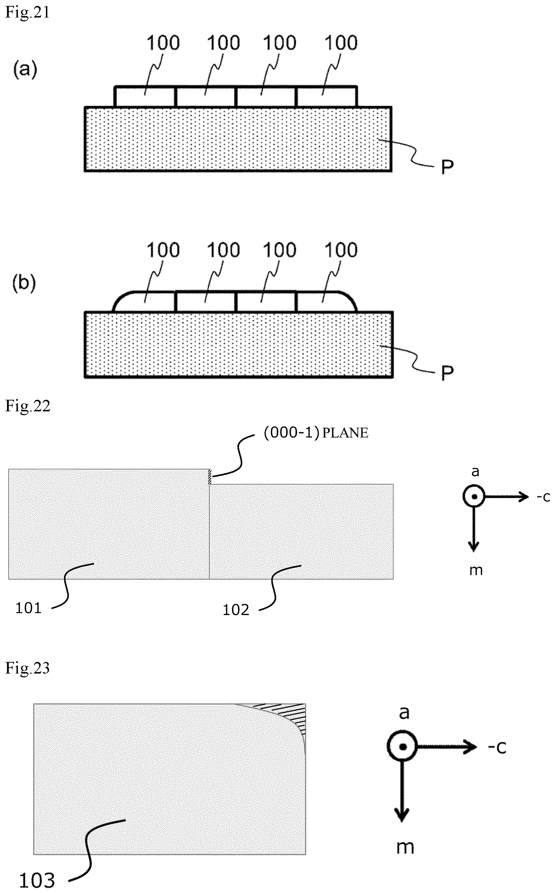

The planarization process is performed in the order of the back surface first and the front surface later (as described above, the main surface used for epitaxial growth of a bulk GaN crystal in the next Step 5 is a front surface, and the main surface on the opposite side is a back surface). In particular, during the planarization of the front surface, as illustrated in the cross-sectional view of Fig. 21(a), a plurality of seeds 100 is fixed onto the planarized surface of a plate P in a densely arranged state (the back surface of the seed is attached to the plate P). As a result, as illustrated in the cross-sectional view of Fig. 21(b), in the tiling GaN seeds 100 after the planarization process, the variation in thicknesses between the seeds is extremely reduced, and the edge roll-off of the surface to be processed (front surface) at the portion where the seeds are in contact with each other is controlled.

In particular, in a case where the angle formed by the front surface and the side surface of the tiling GaN seed is not an obtuse angle, the gap between the front surfaces of adjacent seeds is reduced when a plurality of the seeds are densely arranged and the front surfaces thereof are planarized, generating a preferable control effect of edge roll-off.

### (Step 5)

A plurality of tiling GaN seeds, which is densely arranged on the planarized surface of a plate and has front surfaces that have been planarized, is fixed onto a metal plate such as molybdenum with the front surfaces facing up in the same arrangement as being fixed on the plate to form aggregate seeds. Molybdenum and tungsten are suitably used as the material of the metal plate. A plurality of holes are formed in the metal plate, and in accordance with the positions of the holes, holes are formed in tiling seeds. Tiling seeds are placed on the metal plate, and bound and fixed with a wire. In this state, a GaN layer crystal is epitaxially grown on the aggregate seeds by an ammonothermal method to obtain a bulk crystal. The merits of using a metal plate as the fixing plate as described above is that there is no restriction on the size of the fixing plate. For example, in a case where an M-plane GaN seed is used as the fixing plate similarly to the tiling GaN seed, the size of the obtained aggregate seeds is also limited according to the size of the tiling GaN seed used as the fixing plate. On the other hand, since it is easy to prepare a metal plate having any size, there is no limitation on the size. In addition, as a result of studies by the present inventors, it has been confirmed that a good GaN crystal is obtained even when the above-described metal plate is used as the fixing plate of the tiling GaN seed on the M-plane or the S-plane. Preferably, a process of epitaxially growing a GaN crystal layer on aggregate seeds by an ammonothermal method includes a meltback process (treatment of dissolving a GaN crystal layer on a seed surface by reversing a temperature). In a case where the meltback process is included, the GaN layer at the bonding portion between the plurality of tiling GaN seeds constituting the aggregate seeds is partially dissolved, and the damaged layer on the bonding surface caused by dicing is removed, so that bonding is improved. As a result, a GaN crystal having a narrow band-shaped dislocation-concentrated region derived from the bonding portion can be obtained.

### (Step 5')

The plurality of tiling GaN seeds, which is densely arranged on the planarized surface of a plate and has front surfaces that have been planarized, is subjected to sagging treatment. The "sagging treatment" means that an edge portion is removed such that a (000-1) plane is not exposed at the edge portion consisting of an intersection of an end portion of a main surface on a (000-1) side and an end portion of the (000-1) plane of the tiling GaN seed. Typically, the main surface of the seed and the (000-1) plane are connected by drawing a curve by removal of the edge portion. This state may be expressed as "an edge sag".

Preferably, the edge portion is removed so that the (000-1) plane is not exposed in a region of 1 to 20 µm in the depth direction from the surface in the edge portion. The region in the depth direction is more preferably about 5 to 15 µm, and still more preferably about 8 to 12 µm. The edge portion is preferably removed by a polishing process.

The plurality of tiling GaN seeds, which is densely arranged on the planarized surface of a plate and has front surfaces that have been planarized, is provided on one plate and is preferably subjected to the above process at one time.

According to the study of the present inventors, it has been found that in a case where an unintended difference occurs in the heights of the seeds when the tiling GaN seeds are arranged, and the (000-1) plane at the edge portion consisting of the intersection of the end portion of the main surface on the (000-1) side and the end portion of the (000-1) plane is exposed, the exposed (000-1) plane serves as a starting point of the defect, and the defect above and around the bonding portion increases. As described above, by removing the edge portion such that the edge of the main surface on the (000-1) side to sag, the exposure of the (000-1) plane is minimized when end seeds are arranged, and the width of the defect derived from the bonding portion, that is, the band-shaped dislocation-concentrated region can be narrowed.

A specific description will be given with reference to the drawings. Fig. 22 illustrates a case where an unintended difference in heights between seeds occurs when the seeds that are not subjected to the "sagging treatment" described above are bonded to each other. In Fig. 22, because of an unintended height difference between a seed 101 and a seed 102, a (000-1) plane is exposed at an edge portion on the (000-1) side of the main surface of the seed 101. In such a case, a defect occurs above and around the bonding portion with the exposed (000-1) plane as a starting point.

Fig. 23 illustrates a case where an edge portion is removed such that a (000-1) plane is not exposed at the edge portion consisting of an intersection of an end portion of the main surface of the seed 103 on the (000-1) side and an end portion of the (000-1) plane (a case where "sagging treatment" is carried out). A hatched portion in Fig. 23 represents the removed edge portion.

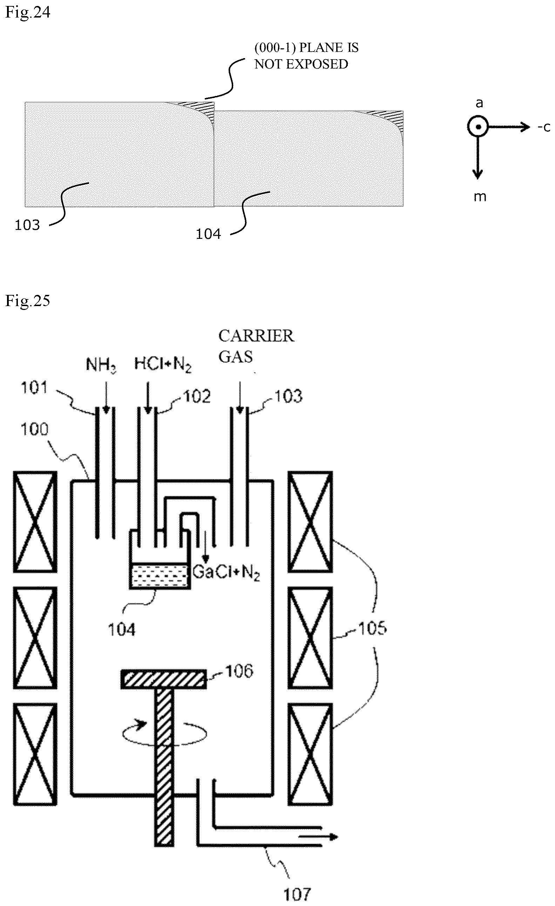

Fig. 24 illustrates a case where an unintended difference in heights between seeds occurs when the seeds that are subjected to "sagging treatment" described above are bonded to each other. In Fig. 24, unlike the case of Fig. 22, an edge portion of the main surface of a seed 103 on the (000-1) side is removed by the "sagging treatment", a (000-1) plane is thus not exposed in the boundary region even when there is an unintended height difference between the seed 103 and a seed 104.

### (Step 6')

A plurality of tiling GaN seeds, which is densely arranged on the planarized surface of a plate and has front surfaces that have been planarized, is densely arranged on a susceptor of an HVPE apparatus with the front surfaces thereof facing up in the same arrangement as being fixed on the plate to form aggregate seeds. A bulk GaN crystal is epitaxially grown on the aggregate seeds by an HVPE method.

### 3.2. Vapor-Phase Growth Process

In a vapor-phase growth process, a bulk GaN crystal is grown by an HVPE method using the bulk GaN crystal obtained in the liquid-phase growth process as a seed crystal.

The bulk GaN crystal obtained in the liquid-phase growth process described above can be processed by a known method to be used as a seed for crystal growth in the HVPE method. For example, the grown bulk GaN crystal is sliced in seed-parallel to form a wafer shape. At this time, it is preferable to adjust the slice direction so that the main surface of the wafer is inclined by a specific angle in the [000-1] direction with respect to the M-plane. The angle is preferably an inclination of the main surface of the wafer with respect to the M-plane in the [000-1] direction by 0.1 to 10 degrees, more preferably 1 to 8 degrees, and still more preferably 4 to 6 degrees. After slicing, both main surfaces of the wafer are subjected to a planarization process to obtain an M-plane GaN wafer.

The growth of the GaN crystal by the HVPE method can be performed using a vapor-phase growth apparatus illustrated in the conceptual diagram of Fig. 25. However, in this step, it is preferable to use the whole or substantially whole (99% or more) of a carrier gas as a nitrogen gas.

In a case where a GaN crystal is grown by the HVPE method, it is preferable to perform a two-stage growth method including (a) a temperature increasing step, (b) a pre-growth step, and (c) a main growth step described below in this order in order to occur the step flow growth mode as soon as possible at the initial stage.

### (a) Temperature Increasing Step

In a temperature increasing step, the susceptor temperature is increased from room temperature to T1 without supplying gallium chloride to a seed. T1 is preferably 830°C or higher and 870°C or lower. The temperature increasing rate is preferably 12°C/min or more and 30°C/min or less. The temperature increasing rate may be constant over the entire period of the temperature increasing step or may be changed in the middle of the temperature increasing step.

An atmosphere gas that can be introduced into the growth furnace in the temperature increasing step is hydrogen gas, ammonia, nitrogen gas, or other gases, and it is preferable to introduce at least both ammonia and nitrogen gas. The volume flow rate of ammonia introduced into the growth furnace is preferably 15% or more of the total volume flow rate of all gases introduced into the growth furnace.

### (b) Pre-Growth Step

In the pre-growth step, the susceptor temperature is increased from T1 to T2 while supplying gallium chloride and ammonia to the seed to epitaxially grow a GaN crystal. T2 is preferably 940°C or higher and 1,200°C or lower. The temperature increasing rate is preferably 6°C/min or more and 24°C/min or less.

In a case where the pressure in the growth furnace in the pre-growth step is 1.0 × 10⁵ Pa, the GaCl partial pressure is preferably 2.0 × 10² Pa or more and 5.0 × 10² Pa or less, and the ammonia partial pressure is preferably 9.3 × 10° Pa or more and 1.2 × 10⁴ Pa or less.

In the pre-growth step and the next main growth step, the whole or substantially whole (99% or more) of the carrier gas supplied into the growth furnace is nitrogen gas.

### (c) Main Growth Step

In the main growth step, while the susceptor temperature is held at T2, gallium chloride and ammonia are supplied onto the seed to epitaxially grow a GaN crystal as a thick film. The pressure in the growth furnace in the main growth step is preferably 50 kPa or more and 120 kPa or less.

In a case where the pressure in the growth furnace in the main growth step is 1.0 × 10⁵ Pa, the GaCl partial pressure is preferably 1.5 × 10² Pa or more and 5.0 × 10² Pa or less, and the ammonia partial pressure is preferably 1.0 × 10³ Pa or more and 1.2 × 10⁴ Pa or less.

According to the two-stage growth method, since crystal growth is started at the temperature T1 lower than the susceptor temperature T2 in the main growth step, a decomposition product of quartz constituting a growth furnace or the like is prevented from adsorbing to the seed surface before the start of the main growth step. The present inventors consider that the decomposition product of quartz adsorbs to the seed surface to reduce the wettability to GaN, and has an action of delaying the occurrence of the step flow growth mode of GaN.

### 3.3. Wafer Fabrication process

In a wafer fabrication process, a GaN wafer with an angle between the normal line of the main surface and the m-axis of 0 degrees or more and 20 degrees or less is fabricated from the bulk GaN crystal obtained in the aforementioned vapor-phase growth process.

The GaN wafer with an angle between the normal line of the main surface and the m-axis of 0 degrees or more and 20 degrees or less is obtained by slicing the bulk GaN crystal obtained in the vapor-phase growth process. The slice direction may be parallel to the front surface of the tiling GaN seed or may be inclined with respect to the surface.

The main surface of the GaN wafer is subjected to a planarization process. Specifically, after grinding and/or lapping is performed, the damaged layer is removed by CMP.

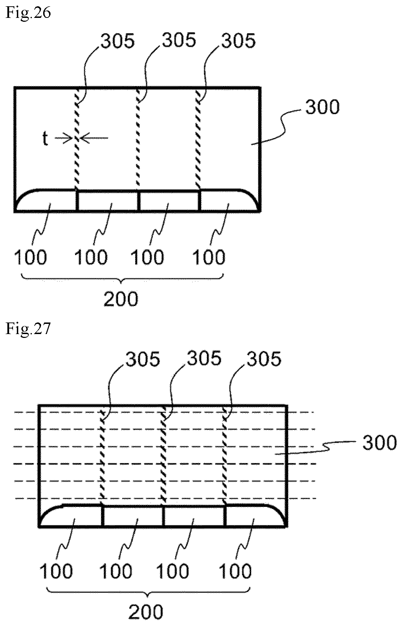

For example, a complex illustrated in Fig. 26 is processed into a cylindrical shape by the outer peripheral grinding process or the core drilling process, and then sliced at the positions indicated by the broken lines in Fig. 27 to obtain the GaN wafer 10 illustrated in Fig. 1. In this case, band-shaped dislocation-concentrated portions 305 in a bulk GaN crystal 300 is exposed on the main surface 11 of the GaN crystal 10 to become the band-shaped dislocation-concentrated regions 14.

For comparison, the present invention will be described in comparison with a conventional method where a plurality of tiling GaN seeds is grown by the HVPE method.

In a conventional method, a plurality of tiling GaN seeds, which is densely arranged on the planarized surface of a plate and has front surfaces that have been planarized, is densely arranged on a susceptor of an HVPE apparatus with the front surfaces thereof facing up in the same arrangement as being fixed on the plate to form aggregate seeds. A method (tiling technique) of epitaxially growing a bulk GaN crystal on the aggregate seeds by an HVPE method, and slicing the obtained bulk GaN crystal to obtain a non-polar or semi-polar GaN wafer has been known. The method of the present invention is different from a conventional tiling technique in that a process of growing a bulk GaN crystal by an ammonothermal method on the aggregate seeds is at least provided. In the conventional tiling technique, the band-shaped dislocation-concentrated regions derived from the defect of the bonding portion between the plurality of tiling GaN seeds constituting the aggregate seeds are widely present on the main surface. On the other hand, in the method of the present invention, the crystal is not directly grown on the aggregate seeds by the HVPE method but is instead first grown on the aggregate seeds by the ammonothermal method. Since the ammonothermal method has a feature of obtaining a crystal having crystal quality superior to that obtained by the HVPE method, it is considered that the quality of the crystal grown around the bonding portion of the aggregate seeds is improved, and the GaN crystal obtained using the crystal as a seed thus has the narrow width of the band-shaped dislocation-concentrated region derived from the defect of the bonding portion. It is also preferable that the process of epitaxially growing the GaN layer crystal on the aggregate seeds by the ammonothermal method includes a meltback process. In a case where the meltback process is included, the GaN layer at the bonding portion between the plurality of tiling GaN seeds constituting the aggregate seeds is partially dissolved, and the damaged layer on the bonding surface caused by dicing is removed, so that bonding between the tiling GaN seeds is improved. Therefore, it is possible to further narrow the width of the band-shaped dislocation-concentrated region derived from the defect of the bonding portion.

In addition, in a conventional method, a plurality of tiling GaN seeds, which is densely arranged on the planarized surface of a plate and has front surfaces that have been planarized, is densely arranged on a susceptor of an HVPE apparatus with the front surfaces thereof facing up in the same arrangement as being fixed on the plate to form aggregate seeds while the "sagging treatment" is not performed. A bulk GaN crystal is then epitaxially grown on the aggregate seeds by an HVPE method, and the obtained bulk GaN crystal is sliced to obtain a non-polar or semi-polar GaN wafer. The method of the present invention is different from the conventional method at least in that the "sagging treatment" is performed on the plurality of tiling GaN seeds, which is densely arranged on the planarized surface of a plate and has front surfaces that have been planarized. In the conventional method, since the (000-1) plane is exposed in the boundary region between the seeds because of an unintended height difference between the plurality of tiling GaN seeds constituting the aggregate seeds, defects are increased starting from the (000-1) plane, and the band-shaped dislocation-concentrated regions are widely present on the main surface. On the other hand, in the method of the present invention, the "sagging treatment" is performed on the plurality of tiling GaN seeds. Since the edge portion of the main surface of the seed on the (000-1) side is removed even when there is an unintended height difference between the seeds in a case where the seeds on which the "sagging treatment" is performed are bonded to each other, the (000-1) plane is not exposed in the boundary region. Therefore, the occurrence of the defect starting from the (000-1) plane is minimized, and it is possible to obtain a GaN crystal with the width of the band-shaped dislocation-concentrated region reduced.

### EXAMPLES

Hereinafter, the present invention will be specifically described with reference to Examples, but the present invention is not limited thereto.

### 4. Experiment Results

### 4.1.1. Example 1

A C-plane GaN wafer was prepared, and a growth mask with a stripe pattern was formed on a (000-1) plane (nitrogen polar surface) thereof by using a TiW alloy. The stripe direction was parallel to the a-axis of GaN, and the width of each opening portion was 100 µm.

On the (000-1) surface of the C-plane GaN wafer on which such a growth mask was formed, a GaN crystal was grown by an ammonothermal method. Polycrystalline GaN was used as a feedstock, and ammonium fluoride (NH₄F) and ammonium iodide (NH₄I) were used as a mineralizer.

The charged amount of the mineralizer was determined such that the molar ratio of each of NH₄F and NH₄I to NH₃ enclosed in a growth vessel was 0.5% to 1.5% and 1.5% to 3.5%, and the molar ratio of NH₄F to NH₄I was 0.2 to 0.5.

As the growth conditions, the average temperature in the growth vessel (the average value of the temperatures in a crystal growth zone and a raw material dissolution zone) was 590°C to 630°C, the difference in temperature between the crystal growth zone and the raw material dissolution zone was 5°C to 20°C, and the pressure in the growth vessel was 200 to 220 MPa.

After growth was carried out for a total of 100 days while 2 times of growth vessel replacement was carried out on the way, a wall-like GaN crystal having the c-axis direction as the height direction and the m-axis direction as the thickness direction was grown at a position of each opening portion of the growth mask.

The above-described GaN crystal grown in a wall shape was removed from a C-plane GaN wafer and processed into a planarized plate (M-plane GaN seed) having a main surface substantially parallel to the M-plane. The main surfaces of the M-plane GaN seed were both planarized by lapping and then subjected to CMP finishing to remove a damaged layer.

Next, a GaN crystal was grown on this M-plane GaN seed by the ammonothermal method again. In the second amonothermal growth, the charged amount of the mineralizer was set so that the molar ratio of each of fluorine atoms and iodine atoms to NH₃ was 1.0%. In addition, the average temperature in the growth vessel was set to 600°C to 611°C, and the difference in temperature between the crystal growth zone and the raw material dissolution zone was set to 9°C to 13°C. The pressure in the growth vessel was the same as that in the first amonothermal growth.

From the GaN crystal formed on the M-plane GaN seed through the second amonothermal growth, a plate-like tiling GaN seed having a thickness of about 330 µm was produced by the following procedure.

First, the GaN crystal was sliced parallel to the M-plane by a multiwire saw. Subsequently, an edge portion of the sliced GaN crystal plate was cut off with a dicing saw, and a main surface thereof was formed into a rectangle having a long side parallel to the a-axis and a short side perpendicular to the a-axis. During cutting with the dicing saw, a saw blade was always brought into contact with the GaN crystal plate from the back surface side. For both the long side and the short side of the rectangle, the deviation from the design direction was set to 0.1° or less.

Thereafter, an end surface of the GaN crystal plate obtained by cutting was subjected to lapping treatment and wet etching treatment in order to remove a damaged layer on the end surface obtained by the dicing saw.

Finally, each main surface of the GaN crystal plate was subjected to a planarization process to complete a tiling GaN seed. Specifically, after grinding and/or lapping was performed in this order, the damaged layer is removed by CMP.

The planarization process was performed in the order of the back surface first and the front surface later. The front surface is a main surface used for epitaxial growth of a bulk GaN crystal by an HVPE method later.

The planarization process was performed on the front surface by attaching five GaN crystal plates densely arranged in the c-axis direction to the planarized surface of the plate with wax. Specifically, the five GaN crystal plates were arranged in a row on the planarized surface of the plate such that an end on one [0001] side and an end on the other [000-1] side were in contact with each other between any two adjacent GaN crystal plates; thereby, the [0001] directions of all the five GaN crystal plates coincided with each other.

Next, five tiling GaN seeds obtained by performing the planarization process on the front surfaces in a densely arranged state were fixed on a metal plate such as molybdenum with the front surfaces facing upward. A plurality of holes is formed in the metal plate, and in accordance with the positions of the holes, holes were formed in tiling seeds. The metal plate and the tiling seeds were bound and fixed with a metal wire such as platinum.

A bulk GaN crystal is epitaxially grown on the aggregate seeds by an ammonothermal method. The growth temperature was 600°C to 610°C, and the growth time was 27 days. Meltback treatment (treatment of dissolving a GaN crystal layer on a surface by reversing a temperature) was performed at the initial stage of growth.

The grown bulk GaN crystal was sliced in seed-parallel to form a wafer. At this time, the slice direction was adjusted so that the main surface of the wafer is inclined by 5° in the [000-1] direction with respect to the M-plane. After slicing, both main surfaces of the wafer were subjected to a planarization process to obtain an M-plane GaN wafer of 45mm × 26mm with an off-angle.

This M-plane GaN wafer with an off-angle was epitaxially grown by the HVPE method. The growth temperature was 1050°C, and the growth time was 10 hours. The carrier gas supplied into a reactor during the growth of the bulk GaN crystal was nitrogen gas alone. In the epitaxial growth by a HVPE method, intentional carbon doping was not performed.

The grown M-plane bulk GaN crystal with an off-angle was evaluated by the following method.

### <Effective width of Band-Shaped Dislocation-Concentrated Region>

A multi-photon excited PL apparatus (A1MP⁺ manufactured by Nikon Corporation) was used for acquiring a light emission distribution image (multi-photon excited PL image) around a band-shaped dislocation-concentrated region on the main surface of the M-plane bulk GaN crystal was acquired. In the wide-area image, a band-shaped dislocation-concentrated region with a longitudinal direction parallel to the a-axis was observed. The observation region of the multi-photon excited PL image was a region of 240 µm × 180 µm, the observation region having a length of 240 µm in the longitudinal direction of the band-shaped dislocation-concentrated region, including the entire band-shaped dislocation-concentrated region, and having a length of 180 µm in a direction perpendicular to the longitudinal direction. For the same band-shaped dislocation-concentrated region, multi-photon excited PL images, each including a region of 240 µm × 180 µm, were acquired at three different locations so that the observation regions were not overlapped with each other.

The observation conditions are as follows.
· Excitation laser: Yb femtosecond laser · pulse width of < 100 fs, repetition frequency 76 MHz
· Wavelength 1,035 nm (using 3 photon excitation or more)
· Set average power to several mW to several 10 mW through acousto-optical element
· Objective lens magnification 50 times (NA 0.80)

Next, for each of the multi-photon excited PL images acquired at three different locations, an integrated profile of image luminance was created by integrating image luminance profiles with a length of 180 µm in the direction perpendicular to the longitudinal direction of the band-shaped dislocation-concentrated region over a longitudinal length of 240 µm of the band-shaped dislocation-concentrated region. In the integrated profile, a baseline was visually drawn. In the integrated profiles obtained from the multi-photon excited PL images acquired at three different locations, there is no region having an image luminance of 80% or less with respect to the image luminance value at the baseline. That is, the effective width of the band-shaped dislocation-concentrated region could not be determined. As a result, the maximum effective width of the band-shaped dislocation-concentrated region of the M-plane bulk GaN crystal with an off-angle of Example 1 was less than 50 µm.

### <Dislocation Density>

The density of dark spots in a specific region was measured from the multi-photon excited PL images of 240 µm × 180 µm acquired at three different locations, which were used for calculating the effective width of the band-shaped dislocation-concentrated region described above, and the dislocation density was calculated.

### · Dislocation Density of Region (X)

A dislocation density in a region (X) defined by two line segments drawn in parallel to a longitudinal direction of a band-shaped dislocation-concentrated region at positions of 5 µm from a center of the band-shaped dislocation-concentrated region in a lateral direction perpendicular to the longitudinal direction was calculated as follows. First, in the multi-photon excited PL image of 240 µm×180 µm, a rectangle of 210 µm × 10 µm was used as an observation region, in which the length of the band-shaped dislocation-concentrated region in the longitudinal direction was 210 µm, and the length in the direction perpendicular to the longitudinal direction was 10 µm. An observation region (X1) was then determined so that the center in the direction perpendicular to the longitudinal direction coincided with the center of the band-shaped dislocation-concentrated region. As described above, in the GaN crystal of Example 1, the effective width of the band-shaped dislocation-concentrated region could not be determined. Thus, the center of the band-shaped dislocation-concentrated region was visually determined from the multi-photon excited PL image. For the remaining two multi-photon excited PL images of 240 µm × 180 µm, the observation region (X2) and the observation region (X3) were determined in the same manner. For each of the observation regions (X1) to (X3), the number of dark spots in the region was measured and divided by the area of the region to calculate a dislocation density. Finally, the average of the dislocation densities in the observation regions (X1) to (X3) was defined as the dislocation density in the region (X). The dislocation density in the region (X) was 7.0 × 10⁵ cm⁻².

### · Dislocation Density of Region (Y)

A dislocation density in a region (Y) defined by two line segments drawn in parallel to a longitudinal direction of a band-shaped dislocation-concentrated region at positions of 15 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 30 µm was used as an observation region, in which the length of the band-shaped dislocation-concentrated region in the longitudinal direction was 210 µm, and the length in the direction perpendicular to the longitudinal direction was 30 µm. The dislocation density in the region (Y) was 3.4 × 10⁵ cm⁻².

### · Dislocation Density of Region (Z)

A dislocation density in a region (Y) defined by two line segments drawn in parallel to a longitudinal direction of a band-shaped dislocation-concentrated region at positions of 50 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 100 µm was used as an observation region, in which the length of the band-shaped dislocation-concentrated region in the longitudinal direction was 210 µm, and the length in the direction perpendicular to the longitudinal direction was 100 µm. The dislocation density in the region (Z) was 2.3 × 10⁵ cm⁻².

### · Ratio (D_{Z}/D_{X}) of dislocation density D_{Z} to dislocation density D_{X}

The ratio (D_{Z}/D_{X}) of the dislocation density (Dz) in the region (Z) to the dislocation density (Dx) in the region (X) was 0.33.

In the GaN crystal of Example 1, a rectangular region of 210 µm × 100 µm in which the dislocation density in the rectangle was more than 1 × 10⁷ cm⁻² could not be found on the main surface.

### 4.1.2. Example 2

For the five tiling GaN seeds obtained by performing the planarization process on the front surfaces in a densely arranged state, which was obtained in the same procedure as in Example 1, the "sagging treatment" of removing an edge portion on the (000-1) plane side of a main surface was performed. Specifically, the edge portion was polished so that the (000-1) plane of the edge portion was not exposed over about 10 µm in the depth direction from the main surface. The sagging treatment was performed by radially placing the five tiling GaN seeds on one plate and performing the polishing thereon at one time.

Subsequently, the five tiling GaN seeds subjected to the sagging treatment were densely arranged on a susceptor of an HVPE apparatus with the front surfaces facing upward to form aggregate seeds. The arrangement of the five seeds in the aggregate seeds was the same as the arrangement at the time of the planarization process of the front surfaces. Epitaxial growth was performed on the aggregate seeds by the HVPE method. The growth temperature was 1050°C, and the growth time was 10 hours. The carrier gas supplied into a reactor during the growth of the bulk GaN crystal was nitrogen gas alone. In the epitaxial growth by a HVPE method, intentional carbon doping was not performed.

The grown M-plane bulk GaN crystal with an off-angle was processed in a wafer shape. The obtained M-plane GaN wafer was evaluated by the following method.

### <Effective width of Band-Shaped Dislocation-Concentrated Region>

A SEM-CL apparatus (JSM-7000F manufactured by JEOL Ltd.) was used for acquiring a light emission distribution image (SEM-CL image) around the band-shaped dislocation-concentrated region on the main surface of the M-plane GaN wafer. In the wide-area image, two band-shaped dislocation-concentrated regions with a longitudinal direction parallel to the a-axis was observed. The observation region of the SEM-CL image was a region of 240 µm × 180 µm, the observation region having a length of 240 µm in the longitudinal direction of the band-shaped dislocation-concentrated region, including the entire band-shaped dislocation-concentrated region, and having a length of 180 µm in a direction perpendicular to the longitudinal direction. For the same band-shaped dislocation-concentrated region, SEM-CL images, each including a region of 240 µm × 180 µm, were acquired at three different locations so that the observation regions were not overlapped with each other. This was performed for the two band-shaped dislocation-concentrated regions, and a total of six SEM-CL images were acquired.

The observation conditions are as follows.
· Electron gun acceleration voltage of 3 kV, irradiation current of 100 pA, and observation magnification of 500 times
· Cathodoluminescence: Mono-CL3 manufactured by Gatan, Inc.
· Panchromatic CL observation mode, detector voltage of < 1300 V

Next, for each of the SEM-CL images acquired at six different locations, an integrated profile of image luminance was created by integrating image luminance profiles with a length of 180 µm in the direction perpendicular to the longitudinal direction of the band-shaped dislocation-concentrated region over a longitudinal length of 240 µm of the band-shaped dislocation-concentrated region. In the integrated profile, a baseline was visually drawn. Among the integrated profiles obtained from the SEM-CL images acquired at 6 different locations, the maximum value of the effective widths was 29 µm. As a result, the maximum effective width of the band-shaped dislocation-concentrated region of the M-plane GaN wafer with an off-angle of Example 1 was less than 50 µm.

### <Dislocation Density>

The density of dark spots in a specific region was measured from the SEM-CL images of 240 µm × 180 µm acquired at three different locations, which were used for calculating the effective width of the band-shaped dislocation-concentrated region described above, and the dislocation density was calculated.

### · Dislocation Density of Region (X)

A dislocation density in a region (X) defined by two line segments drawn in parallel to a longitudinal direction of a band-shaped dislocation-concentrated region at positions of 5 µm from a center of the band-shaped dislocation-concentrated region in a lateral direction perpendicular to the longitudinal direction was calculated as follows. First, in the SEM-CL image of 240 µm×180 µm, a rectangle of 210 µm × 10 µm was used as an observation region, in which the length of the band-shaped dislocation-concentrated region in the longitudinal direction was 210 µm, and the length in the direction perpendicular to the longitudinal direction was 10 µm. An observation region (X1) was then determined so that the center in the direction perpendicular to the longitudinal direction coincided with the center of the band-shaped dislocation-concentrated region. As described above, in the GaN crystal of Example 1, the effective width of the band-shaped dislocation-concentrated region could not be determined. Thus, the center of the band-shaped dislocation-concentrated region was visually determined from the SEM-CL image. For the remaining two SEM-CL images of 240 µm × 180 µm, the observation region (X2) and the observation region (X3) were determined in the same manner. For each of the observation regions (X1) to (X3), the number of dark spots in the region was measured and divided by the area of the region to calculate a dislocation density. Finally, the average of the dislocation densities in the observation regions (X1) to (X3) was defined as the dislocation density in the region (X). The dislocation density in the region (X) was 5.9 × 10⁷ cm⁻².

### · Dislocation Density of Region (Y)

A dislocation density in a region (Y) defined by two line segments drawn in parallel to a longitudinal direction of a band-shaped dislocation-concentrated region at positions of 15 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 30 µm was used as an observation region, in which the length of the band-shaped dislocation-concentrated region in the longitudinal direction was 210 µm, and the length in the direction perpendicular to the longitudinal direction was 30 µm. The dislocation density in the region (Y) was 5.0 × 10⁷ cm⁻².

### · Dislocation Density of Region (Z)

A dislocation density in a region (Z) defined by two line segments drawn in parallel to a longitudinal direction of a band-shaped dislocation-concentrated region at positions of 50 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 100 µm was used as an observation region, in which the length of the band-shaped dislocation-concentrated region in the longitudinal direction was 210 µm, and the length in the direction perpendicular to the longitudinal direction was 100 µm. The dislocation density in the region (Z) was 1.8 × 10⁷ cm⁻².

### · Ratio (D_{Z}/D_{X}) of dislocation density D_{Z} to dislocation density D_{X}

The ratio (D_{Z}/D_{X}) of the dislocation density (Dz) in the region (Z) to the dislocation density (Dx) in the region (X) was 0.31.

### · Ratio (D_{Z}/D_{Y}) of dislocation density D_{Z} to dislocation density Dy

The ratio (D_{Z}/D_{Y}) of the dislocation density (D_{Z}) in the region (Z) to the dislocation density (D_{Y}) in the region (Y) was 0.36.

### 4.2 Comparative Example 1

In Comparative Example, an M-plane GaN crystal with an off-angle of Comparative Example was produced in the same manner as in Examples, except that crystal growth of a bulk GaN crystal was carried out on aggregate seeds composed of five tiling GaN seeds obtained by performing a planarization process on front surfaces in a densely arranged state by an HVPE method without epitaxial growth of the bulk GaN crystal by an ammonothermal method on the aggregate seeds and without performing "sagging treatment". The produced M-plane GaN crystal with an off-angle was processed in a wafer shape. The obtained M-plane GaN wafer was evaluated by the following method.

### <Effective width of Band-Shaped Dislocation-Concentrated Region>

A SEM-CL apparatus (JSM-7000F manufactured by JEOL Ltd.) was used for acquiring a light emission distribution image (SEM-CL image) around the band-shaped dislocation-concentrated region on the main surface of the M-plane bulk GaN crystal. Since the dark spots were present at high density over a wide area as compared to the case of Example 1, a SEM-CL apparatus was used for measuring the density of dark spots accurately. In the wide-area image, three band-shaped dislocation-concentrated regions with a longitudinal direction parallel to the a-axis was observed on the main surface. The observation region of the SEM-CL image was a region of 240 µm × 180 µm, the observation region having a length of 240 µm in the longitudinal direction of the band-shaped dislocation-concentrated region, including the entire band-shaped dislocation-concentrated region, and having a length of 180 µm in a direction perpendicular to the longitudinal direction. For the same band-shaped dislocation-concentrated region, SEM-CL images, each including a region of 240 µm × 180 µm, were acquired at two different locations so that the observation regions were not overlapped with each other. This was performed for the three band-shaped dislocation-concentrated regions, and a total of six SEM-CL images of 240 µm × 180 µm were acquired.

The observation conditions are as follows.
· Electron gun acceleration voltage of 3 kV, irradiation current of 100 pA, and observation magnification of 500 times
· Cathodoluminescence: Mono-CL3 manufactured by Gatan, Inc.
· Panchromatic CL observation mode, detector voltage of < 1300 V

Next, for each of the six SEM-CL images acquired, an integrated profile of image luminance was created by integrating image luminance profiles with a length of 180 µm in the direction perpendicular to the longitudinal direction of the band-shaped dislocation-concentrated region over a longitudinal length of 240 µm of the band-shaped dislocation-concentrated region. In the integrated profile, a baseline was visually drawn. In the four integrated profiles, the effective width that is the width of the region having the image luminance of 80% or less with respect to the value of the image luminance at the baseline was about 50 µm or more. For two of the integrated luminance profiles, there was no flat region corresponding to the region other than the band-shaped dislocation-concentrated region because the dislocations were distributed at high density over a wide area, so that the baseline could not be obtained within the range of the integrated luminance profiles. As a result, the maximum effective width of the band-shaped dislocation-concentrated region of the M-plane GaN wafer of Comparative Example 1 was 50 µm or more.

### <Dislocation Density>

The density of dark spots in a specific region was measured from the SEM-CL images of 240 µm × 180 µm acquired at six different locations, which were used for calculating the effective width of the band-shaped dislocation-concentrated region , and the dislocation density was calculated.

### · Dislocation Density of Region (X)

A dislocation density in a region (X) defined by two line segments drawn in parallel to a longitudinal direction of a band-shaped dislocation-concentrated region at positions of 5 µm from a center of the band-shaped dislocation-concentrated region in a lateral direction perpendicular to the longitudinal direction was calculated as follows. First, in the SEM-CL image of 240 µm×180 µm, a rectangle of 210 µm × 10 µm was used as an observation region, in which the length of the band-shaped dislocation-concentrated region in the longitudinal direction was 210 µm, and the length in the direction perpendicular to the longitudinal direction was 10 µm. An observation region (X1) was then determined so that the center in the direction perpendicular to the longitudinal direction coincided with the center of the band-shaped dislocation-concentrated region. For the remaining two SEM-CL images of 240 µm × 180 µm, the observation region (X2) and the observation region (X3) were determined in the same manner. For each of the observation regions (X1) to (X3), the number of dark spots in the region was measured and divided by the area of the region to calculate a dislocation density. Finally, the average of the dislocation densities in the observation regions (X1) to (X3) was defined as the dislocation density in the region (X). The dislocation density in the region (X) was 4.7 × 10⁷ cm⁻².

### · Dislocation Density of Region (Y)

A dislocation density in a region (Y) defined by two line segments drawn in parallel to a longitudinal direction of a band-shaped dislocation-concentrated region at positions of 15 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 30 µm was used as an observation region, in which the length of the band-shaped dislocation-concentrated region in the longitudinal direction was 210 µm, and the length in the direction perpendicular to the longitudinal direction was 30 µm. The dislocation density in the region (Y) was 4.2 × 10⁷ cm⁻².

### · Dislocation Density of Region (Z)

A dislocation density in a region (Z) defined by two line segments drawn in parallel to a longitudinal direction of a band-shaped dislocation-concentrated region at positions of 50 µm from a center of the band-shaped dislocation-concentrated region in a lateral direction perpendicular to the longitudinal direction was calculated. A method similar to the method for calculating the dislocation density of the region (X) was used, except that a rectangle of 210 µm × 100 µm was used as an observation region, in which the length of the band-shaped dislocation-concentrated region in the longitudinal direction was 210 µm, and the length in the direction perpendicular to the longitudinal direction was 100 µm. The dislocation density in the region (Z) was 2.7 × 10⁷ cm⁻².

### · Ratio (D_{Z}/D_{X}) of dislocation density D_{Z} to dislocation density D_{X}

The ratio (D_{Z}/D_{X}) of the dislocation density (Dz) in the region (Z) to the dislocation density (Dx) in the region (X) was 0.57.

### · Ratio (D_{Z}/D_{Y}) of dislocation density D_{Z} to dislocation density Dy

The ratio (D_{Z}/D_{Y}) of the dislocation density (D_{Z}) in the region (Z) to the dislocation density (D_{Y}) in the region (Y) was 0.64.

In the GaN crystal of Comparative Example 1, a rectangular region of 210 µm × 100 µm in which the dislocation density in the rectangle was more than 1 × 10⁷ cm⁻² could be found on the main surface.

Although the present invention has been described with reference to specific embodiments, each embodiment is presented as an example and does not limit the scope of the present invention. In other words, each embodiment described in the present specification can be variously modified without departing from the spirit thereof and can be combined with features described by other embodiments within the scope of applicability.

### Reference Signs List

10, 20, 30 GaN crystal
11, 21 First main surface
12 Second main surface
13, 23 Side surface
14, 24-1, 24-2 Band-shaped dislocation-concentrated region
16 Main surface
17 Measurement line
100 Tiling GaN seed
101, 102 Tiling GaN seed without "sagging treatment"
103, 104 Tiling GaN seed with "sagging treatment"
200 Aggregate seeds
300 Bulk GaN crystal
305 Band-shaped dislocation-concentrated portion
400 Center of band-shaped dislocation-concentrated region
501 Line segment defining region (Y)
502 Line segment defining region (Z)
503 Line segment defining region (X)
601 Region (Y)
602 Region (Z)
603 Region (X)
P Plate
w Effective width of band-shaped dislocation-concentrated region

## Claims

1. A GaN crystal comprising a main surface with an angle between a normal line of the main surface and an m-axis of 0 degrees or more and 20 degrees or less, wherein
the GaN crystal has one or more band-shaped dislocation-concentrated regions on the main surface, and
the GaN crystal satisfies at least one requirement selected from the group consisting of (1), (2), and (3) as follows:
(1) each band-shaped dislocation-concentrated region has a maximum effective width of less than 50 µm;
(2) each band-shaped dislocation-concentrated region satisfies at least one of a requirement (A) or a requirement (B), where
(A) a dislocation density in a region (Y) defined by two line segments drawn in parallel to a longitudinal direction of the band-shaped dislocation-concentrated region at positions of 15 µm from a center of the band-shaped dislocation-concentrated region in a lateral direction perpendicular to the longitudinal direction is less than 3 × 10⁷ cm⁻², and
(B) a dislocation density in a region (Z) defined by two line segments drawn in parallel to a longitudinal direction of the band-shaped dislocation-concentrated region at positions of 50 µm from a center of the band-shaped dislocation-concentrated region in a lateral direction perpendicular to the longitudinal direction is less than 2.5 × 10⁷ cm⁻²; and
(3) a ratio (D_{Z}/D_{X}) of the dislocation density D_{Z} to the dislocation density D_{X} defined below is 0.5 or less, and/or a ratio (D_{Z}/D_{Y}) of the dislocation density D_{Z} to the dislocation density Dy defined below is 0.5 or less, where
the dislocation density Dx: a dislocation density in a region (X) defined by two line segments drawn in parallel to a longitudinal direction of the band-shaped dislocation-concentrated region at positions of 5 µm from a center of the band-shaped dislocation-concentrated region in a lateral direction perpendicular to the longitudinal direction;
the dislocation density D_{Y}: a dislocation density in a region (Y) defined by two line segments drawn in parallel to a longitudinal direction of the band-shaped dislocation-concentrated region at positions of 15 µm from a center of the band-shaped dislocation-concentrated region in a lateral direction perpendicular to the longitudinal direction; and
the dislocation density D_{Z}: a dislocation density in a region (Z) defined by two line segments drawn in parallel to a longitudinal direction of the band-shaped dislocation-concentrated region at positions of 50 µm from a center of the band-shaped dislocation-concentrated region in a lateral direction perpendicular to the longitudinal direction.

2. The GaN crystal according to claim 1, wherein in the requirement (B), the dislocation density in the region (Z) defined by two line segments drawn in parallel to the longitudinal direction of the band-shaped dislocation-concentrated region at the positions of 50 µm from the center of the band-shaped dislocation-concentrated region in the lateral direction perpendicular to the longitudinal direction is less than 1 × 10⁷ cm⁻².

3. The GaN crystal according to claim 1, wherein
(2) each band-shaped dislocation-concentrated region satisfies the requirement (B), and
in the requirement (B), the dislocation density in the region (Z) defined by two line segments drawn in parallel to the longitudinal direction of the band-shaped dislocation-concentrated region at the positions of 50 µm from the center of the band-shaped dislocation-concentrated region in the lateral direction perpendicular to the longitudinal direction is 1.0 × 10⁶ cm⁻² or more and less than 2.5 × 10⁷ cm⁻².

4. The GaN crystal according to claim 1, wherein the GaN crystal satisfies (1).

5. The GaN crystal according to claim 1, wherein the GaN crystal satisfies (2).

6. The GaN crystal according to claim 1, wherein the GaN crystal satisfies (3).

7. The GaN crystal according to claim 1, wherein the GaN crystal satisfies all of (1), (2), and (3).

8. The GaN crystal according to claim 1, wherein the main surface has an area of 10 cm² or more.

9. The GaN crystal according to claim 1, wherein a dislocation density in a region other than each band-shaped dislocation-concentrated region of the main surface is 1 × 10⁶ cm⁻² or less.

10. The GaN crystal according to claim 1, wherein the GaN crystal has a carbon concentration of 1 × 10¹⁷ cm⁻³ or less in crystal.

11. The GaN crystal according to claim 1, wherein an absorption coefficient is 1 cm⁻¹ or more at a wavelength of 445 nm, and an N-H peak at 3050 to 3300 cm⁻¹ in an infrared absorption spectrum is not observed.

12. A GaN crystal comprising a main surface with an angle between a normal line of the main surface and an m-axis of 0 degrees or more and 20 degrees or less, wherein
the main surface has an area of 10 cm² or more, and
in a case where a rectangular region of 210 µm × 100 µm is set at any position on the main surface, and a dislocation density in a rectangle is calculated, a rectangular region where the dislocation density in the rectangle is more than 1 × 10⁷ cm⁻² is not present on the main surface.

13. The GaN crystal according to claim 12, wherein the GaN crystal has a carbon concentration of 1 × 10¹⁷ cm⁻³ or less in crystal.

14. The GaN crystal according to claim 12, wherein an absorption coefficient is 1 cm⁻¹ or more at a wavelength of 445 nm, and an N-H peak at 3050 to 3300 cm⁻¹ in an infrared absorption spectrum is not observed.

15. A GaN wafer comprising the GaN crystal according to any one of claims 1 to 14.

16. The GaN wafer according to claim 15, wherein the GaN wafer includes a {10-10} wafer, a {10-11} wafer, a {10-1-1} wafer, a {20-21} wafer, a {20-2-1} wafer, a {30-31} wafer, or a {30-3-1} wafer.

17. A method for producing a GaN crystal, the method comprising at least: a liquid-phase growth process of growing a bulk GaN crystal by an ammonothermal method on aggregate seeds obtained by dense arrangement of a plurality of tiling GaN seeds; and a vapor-phase growth process of growing a GaN crystal by an HVPE method by using the bulk GaN crystal obtained in the liquid-phase growth process as a seed crystal, wherein the liquid-phase growth process includes a meltback process.

18. A method for producing a GaN crystal, the method comprising at least: an aggregate seed-preparation process of preparing aggregate seeds including a plurality of tiling GaN seeds densely arranged; and a vapor-phase growth process of growing a GaN crystal on the aggregate seeds by an HVPE method, wherein the aggregate seed-preparation process includes a process of removing an edge portion such that a (000-1) plane is not exposed at the edge portion consisting of an intersection of an end portion of a main surface on a (000-1) side and an end portion of the (000-1) plane of each tiling GaN seed.
